# EUROPEAN PATENT APPLICATION

(11) **EP 4 475 651 A1**
(43) Date of publication of application: **11.12.2024**
(21) Application number: 24180743.7
(22) Date of filing: 07.06.2024
(51) Int. Cl.: H10K 59/35, H10K 59/38, H10K 59/80

(54) **DISPLAY DEVICE**

(30) Priority: 09.06.2023 KR 20230074083
(71) Applicant: Samsung Display Co., Ltd., Yongin-si, Gyeonggi-Do 17113 (KR)
(72) Inventor: HONG, Sang Min, 17113 Giheung-Gu, Yongin-si, Gyeonggi-Do (KR); KIM, Seung Han, 17113 Giheung-gu, Yongin-si, Gyeonggi-do (KR); HEO, Na Ri, 17113 Giheung-gu, Yongin-si, Gyeonggi-do (KR); KIM, Young Tae, 17113 Giheung-gu, Yongin-si, Gyeonggi-do (KR); SONG, Hyun Gue, 17113 Giheung-gu, Yongin-si, Gyeonggi-do (KR); JUNG, Hyun Ho, 17113 Giheung-gu, Yongin-si, Gyeonggi-do (KR); JEONG, Hee Seong, 17113 Giheung-gu, Yongin-si, Gyeonggi-do (KR); JOO, Sun Jin, 17113 Giheung-gu, Yongin-si, Gyeonggi-do (KR)
(74) Representative: Dr. Weitzel & Partner

(57) **Abstract**

A display device includes: a display layer including a display area and a non-display area; a touch sensor layer overlapping the display area; and a light conversion layer on the touch sensor layer and overlapping the display area; wherein the display device includes: a first light emitting element emitting light of a first wavelength; a second light emitting element emitting light of a second wavelength; a capping layer; a 1-1 and 1-2 encapsulation layers on the capping layer and including inorganic insulating layers; and a second encapsulation layer and a third encapsulation layer sequentially on the 1-1 and 1-2 encapsulation layers, wherein a thickness and a refractive index of a plurality of inorganic insulating layers of the 1-2 encapsulation layer are different from that of inorganic insulating layers of the 1-1 encapsulation layer, wherein a dielectric constant of the second encapsulation layer is 3.0 or less.

## Description

### BACKGROUND

### 1. Field

The present invention relates to a display device.

### 2. Description of the Related Art

As the information society develops, consumer demand for display devices for displaying images is increasing in various forms. For example, display devices may be applied to various electronic devices such as smart phones, digital cameras, notebook computers, navigation systems, and smart televisions. A display device may be a flat panel display device such as a liquid crystal display device, a field emission display device, an organic light emitting display device, and the like. Among such flat panel display devices, a light emitting display device generally includes a light emitting element capable of emitting light by itself in each of the pixels of the display panel, so that images may be displayed without a backlight unit providing light to the display panel.

The above information disclosed in this Background section is only for enhancement of understanding of the background and therefore the information discussed in this Background section does not necessarily constitute prior art.

### SUMMARY

The present invention provides a display device having relatively improved light efficiency and viewing angle characteristics, including a stacked structure in which a plurality of inorganic insulating layers are arranged.

However, aspects of embodiments according to the present invention are not restricted to those specifically set forth herein. The above and other aspects of embodiments according to the present invention will become more apparent to one of ordinary skill in the art to which the present invention pertains by referencing the detailed description of embodiments according to the present invention given below.

The present invention is defined by the features of claim 1. The dependent claims describe preferred embodiments.

According to the present invention, a display device, for example comprising a display layer including a display area and a non-display area surrounding the display area, a touch sensor layer overlapping a portion of the display area of the display device, and a light conversion layer on the touch sensor layer and overlapping a portion of a display area of the display device, includes a first light emitting element in a first light emitting area and emitting light of a first wavelength, a second light emitting element in a second light emitting area and emitting light of a second wavelength, a capping layer on the first light emitting element and the second light emitting element, a 1-1 encapsulation layer, which is also termed as a first light emitting area encapsulation layer, on a capping layer of the first light emitting area and including a plurality of inorganic insulating layers, a 1-2 encapsulation layer, which is also termed as a second light emitting area encapsulation layer, on a capping layer of the second light emitting area and including a plurality of inorganic insulating layers and a second encapsulation layer and a third encapsulation layer sequentially on the 1-1 encapsulation layer and the 1-2 encapsulation layer, wherein thickness and refractive index of a plurality of inorganic insulating layers of the 1-2 encapsulation layer are different from thickness and refractive index of a plurality of inorganic insulating layers of the 1-1 encapsulation layer.

According to some embodiments, a dielectric constant of the second encapsulation layer is 2.0 to 3.0 or less.

According to some embodiments, the second encapsulation layer has a thickness of 8 µm to 9 µm or 10 µm (micrometer) to 11 µm.

According to some embodiments, the 1-1 encapsulation layer sequentially includes an optical layer, a first moisture barrier layer, an auxiliary layer, and an upper layer, wherein the 1-2 encapsulation layer sequentially includes a first optical layer, a second optical layer, a second moisture barrier layer, and an upper layer.

According to some embodiments, the optical layer and the first optical layer include silicon oxynitride, wherein the first moisture barrier layer and the second optical layer include silicon nitride, wherein the auxiliary layer and the second moisture barrier layer include silicon oxynitride, wherein the upper layer includes silicon oxynitride having a high oxygen content (e.g., an oxygen content exceeding a threshold). For example, the upper layer includes silicon oxynitride having a higher oxygen content than the optical layer and/or the first optical layer and/or the auxiliary layer and/or the second moisture barrier layer.

According to some embodiments, the optical layer and the first optical layer have a refractive index in the range of 1.20 to 1.62, wherein the first moisture barrier layer and the second optical layer have a refractive index in the range of 1.70 to 1.90, wherein the auxiliary layer and the second moisture barrier layer have a refractive index in the range of 1.50 to 1.62, and the auxiliary layer, and the refractive index of the of the auxiliary layer and/or the second moisture barrier layer is greater than the refractive index of the optical layer and the first optical layer, wherein the upper layer has a refractive index in the range of 1.50 to 1.80, and the upper layer has a refractive index smaller than that of the auxiliary layer and/or the second moisture barrier layer.

According to some embodiments, the optical layer, the first optical layer, and the second optical layer have a thickness in the range of 40 nm (nanometer) (400 Å) to 200 nm (2000 Å), the second optical layer may be thicker than the first optical layer, wherein the first moisture barrier layer and the second moisture barrier layer have a thickness in the range of 400 nm (4000 Å) to 900 nm (9000 Å), wherein the auxiliary layer and the upper layer have a thickness ranging from 60 nm (600 Å) to 140 nm (1400 Å), and the upper layer is thicker than the thickness of the auxiliary layer.

According to some embodiments, the optical layer has a thickness of 100 nm (1000 Å), the first moisture barrier layer has a thickness of 900 nm (9000 Å), the auxiliary layer has a thickness of 65 nm (650 Å), and the upper layer has a thickness of 80 nm (800 Å),

According to some embodiments, the first optical layer has a thickness of 85 nm (850 Å), the second optical layer has a thickness of 125 nm (1250 Å), and the second moisture barrier layer has a thickness of 800 nm (8000 Å).

According to some embodiments, the 1-1 encapsulation layer sequentially includes an optical layer, a first moisture barrier layer, an auxiliary layer, and an upper layer, wherein the 1-2 encapsulation layer sequentially includes a first optical layer, a second optical layer, and a second moisture barrier layer.

According to some embodiments, the optical layer and the first optical layer include silicon oxynitride, wherein the first moisture barrier layer and the second optical layer include silicon nitride, wherein the auxiliary layer and the second moisture barrier layer include silicon oxynitride, wherein the upper layer includes silicon oxynitride having a high oxygen content (e.g., an oxygen content exceeding a threshold value). For example, the upper layer includes silicon oxynitride having a higher oxygen content than the optical layer and/or the first optical layer and/or the auxiliary layer and/or the second moisture barrier layer.

According to some embodiments, the optical layer and the first optical layer have a refractive index in the range of 1.20 to 1.62, wherein the first moisture barrier layer and the second optical layer have a refractive index in the range of 1.70 to 1.90, wherein the auxiliary layer and the second moisture barrier layer have a refractive index in the range of 1.50 to 1.62, and the auxiliary layer, and the refractive index of the of the auxiliary layer and/or the second moisture barrier layer is greater than the refractive index of the optical layer and the first optical layer, wherein the upper layer has a refractive index in the range of 1.50 to 1.80, and the upper layer has a refractive index smaller than that of the auxiliary layer and/or the second moisture barrier layer.

According to some embodiments, the optical layer, the first optical layer, and the second optical layer have a thickness in the range of 40 nm (400 Å) to 200 nm (2000 Å), the second optical layer may be thicker than the first optical layer, wherein the first moisture barrier layer and the second moisture barrier layer have a thickness in the range of 400 nm (4000 Å) to 900 nm (9000 Å), wherein the auxiliary layer and the upper layer have a thickness ranging from 60 nm (600 Å) to 140 nm (1400 Å), and the upper layer is thicker than the thickness of the auxiliary layer.

According to some embodiments, the optical layer has a thickness of 100 nm (1000 Å), the first moisture barrier layer has a thickness of 900 nm (9000 Å), the auxiliary layer has a thickness of 65 nm (650 Å), and the upper layer has a thickness of 80 nm (800 Å), wherein the first optical layer has a thickness of 85 nm (850 Å), the second optical layer has a thickness of 125 nm (1250 Å), and the second moisture barrier layer has a thickness of 800 nm (8000 Å).

According to some embodiments, the 1-1 encapsulation layer sequentially includes a first optical layer, a second optical layer, a moisture barrier layer, and an upper layer, wherein the 1-2 encapsulation layer sequentially includes a first optical layer, a second optical layer, and a moisture barrier layer, wherein the second encapsulation layer is directly on the moisture barrier layer.

According to some embodiments, the first optical layer includes silicon oxynitride, wherein the second optical layer includes silicon nitride, wherein the moisture barrier layer includes silicon oxynitride, wherein the upper layer includes silicon oxynitride having a high oxygen content (e.g., an oxygen content exceeding a threshold). For example, the upper layer includes silicon oxynitride having a higher oxygen content than the moisture barrier layer.

According to some embodiments, the first optical layer has a refractive index in the range of 1.20 to 1.62, wherein the second optical layer has a refractive index in the range of 1.70 to 1.90, wherein the moisture barrier layer has a refractive index in the range of 1.50 to 1.62, greater than the refractive index of the first optical layer, wherein the upper layer has a refractive index ranging from 1.50 to 1.80, and the upper layer has a refractive index smaller than that of the moisture barrier layer.

According to some embodiments, the first optical layer and the second optical layer have a thickness in the range of 40 nm (400 Å) to 200 nm (2000 Å), the second optical layer is thicker than the thickness of the first optical layer, wherein the moisture barrier layer has a thickness in the range of 400 nm (4000 Å) to 900 nm (9000 Å), wherein the upper layer has a thickness in the range 60 nm (600) Å to 140 nm (1400 Å).

According to some embodiments, the first optical layer has a thickness of 85 nm (850 Å), the second optical layer has a thickness of 125 nm (1250 Å), the moisture barrier layer has a thickness of 800 nm (8000 Å), and the upper layer has a thickness of 80 nm (800 Å).

According to some embodiments, the 1-1 encapsulation layer sequentially includes a first optical layer, a second optical layer, a moisture barrier layer, a buffer layer, and an upper layer, wherein the 1-2 encapsulation layer sequentially includes a first optical layer, a second optical layer, a moisture barrier layer, and an upper layer.

According to some embodiments, the first optical layer includes silicon oxynitride, wherein the second optical layer includes silicon nitride, wherein the moisture barrier layer and the buffer layer include silicon oxynitride, wherein the upper layer includes silicon oxynitride having a high oxygen content (e.g., an oxygen content exceeding a threshold). For example, the upper layer includes silicon oxynitride having a higher oxygen content than the moisture barrier layer and the buffer layer.

According to some embodiments, the first optical layer has a refractive index in the range of 1.20 to 1.62, wherein the second optical layer has a refractive index in the range of 1.70 to 1.90, wherein the moisture barrier layer has a refractive index in the range of 1.50 to 1.62, greater than the refractive index of the first optical layer, wherein the upper layer has a refractive index in the range of 1.50 to 1.80, wherein the buffer layer has a refractive index smaller than that of the moisture barrier layer and greater than that of the upper layer.

According to some embodiments, the first optical layer and the second optical layer have a thickness in the range of 40 nm (400 Å) to 200 nm (2000 Å), the second optical layer is thicker than the thickness of the first optical layer, wherein the moisture barrier layer has a thickness in the range of 400 nm (4000 Å) to 900 nm (9000 Å), wherein the buffer layer and the upper layer have a thickness ranging from 60 nm (600 Å) to 140 nm (1400 Å).

According to some embodiments, the first optical layer has a thickness of 85 nm (850 Å), the second optical layer has a thickness of 125 nm (1250 Å), the moisture barrier layer has a thickness of 800 nm (8000 Å), the buffer layer has a thickness of 80 nm (800 Å), and the upper layer has a thickness of 80 nm (800 Å).

According to some embodiments, the capping layer has a refractive index greater than that of the first optical layer.

According to some embodiments, a dielectric constant of the second encapsulation layer is 2.0 to 3.0.

According to some embodiments, the display device comprises a light conversion layer on the third encapsulation layer, wherein the light conversion layer is one of a color filter or a polarizing plate.

According to some embodiments, the display device may include a stacked structure of layers having different refractive indices, so that light efficiency of a light emitting element, light emission efficiency of lights emitted from the light emitting element, and viewing angle characteristics may be controlled as desired.

However, the characteristics of embodiments according to the present invention are not limited to the aforementioned characteristics, and various other characteristics are included in embodiments according to the present invention.

### BRIEF DESCRIPTION OF THE DRAWINGS

FIG. 1 is a schematic plan view of a display device according to some embodiments.
FIG. 2 is a perspective view illustrating a display device included in an electronic device according to some embodiments.
FIG. 3 is a cross-sectional view of the display device of FIG. 2 viewed from the side according to some embodiments.
FIG. 4 is a plan view illustrating a display layer of a display device according to some embodiments.
FIG. 5 is a layout diagram illustrating further details of a touch sensing layer according to some embodiments.
FIG. 6 is a layout diagram illustrating further details of an example of the touch node of FIG. 5 according to some embodiments.
FIG. 7 is a cross-sectional view illustrating an example of a display panel taken along the line B-B' of FIG. 6 according to some embodiments.
FIG. 8 is a cross-sectional view illustrating a stacked structure of a light emitting element and an encapsulation layer of a display device according to some embodiments.
FIG. 9 is a cross-sectional view illustrating in detail a stacked structure of a light emitting element and an encapsulation layer of a display device according to some embodiments.
FIG. 10 is a cross-sectional view illustrating in more detail a stacked structure of a light emitting element and an encapsulation layer of a display device according to some embodiments.
FIG. 11 is a cross-sectional view illustrating in more detail the laminated structure of the light emitting element and the envelope layer of a display device according to some embodiments.
FIGS. 12 to 15 are cross-sectional views illustrating a stacked structure of a light emitting element and an encapsulation layer of a display device according to some embodiments.

### DETAILED DESCRIPTION

Aspects of some embodiments of the present invention will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity.

Some of the parts which are not associated with the description may not be provided in order to describe embodiments of the invention.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B" or any combination of A and/or B.

Unless otherwise defined or implied, all terms used herein (including technical and scientific terms) have the same meaning as commonly understood by those skilled in the art to which this invention pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, aspects of some embodiments of the present invention will be described in more detail with reference to the accompanying drawings.

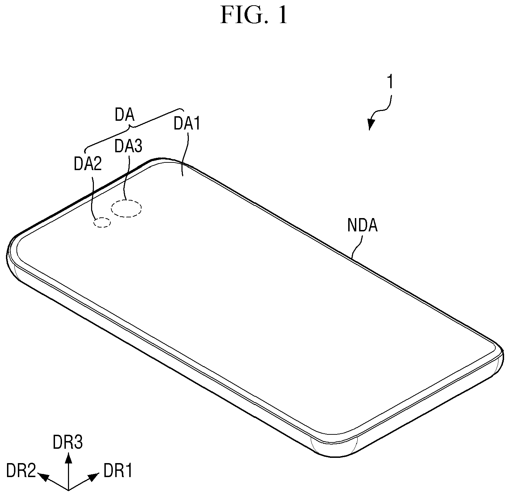

FIG. 1 is a schematic plan view of a display device according to some embodiments.

Referring to FIG. 1, the electronic device 1 displays a moving image or a still image. The electronic device 1 may refer to any electronic device having a display screen or display device configured to display images. For example, the electronic device 1 may include a television, laptop, monitor, billboard, Internet of Things, mobile phone, smartphone, tablet personal computer (PC), electronic watch, smartwatch, watch phone, head-mounted display, mobile communication terminal, electronic notebook, e-book, portable multimedia player (PMP), navigation device, gaming device, digital camera, camcorder, etc. that provides a display screen or display device.

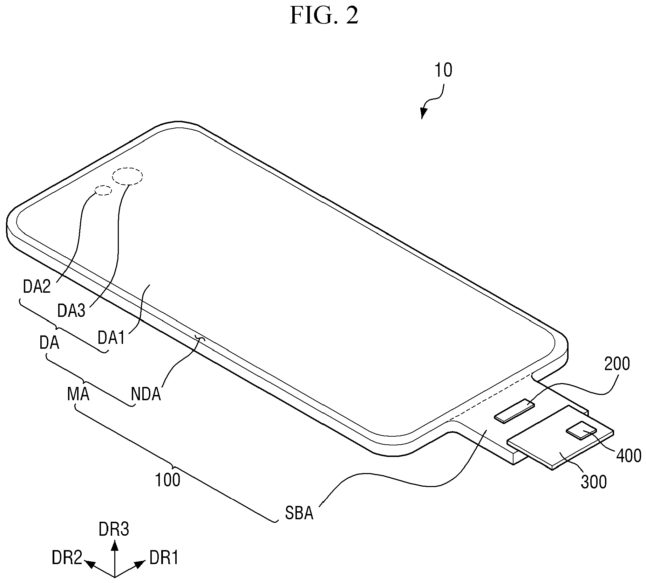

The electronic device 1 may include a display device (see, e.g., display device 10 in FIG. 2) providing a display screen. Examples of the display device include an inorganic light emitting diode display device, an organic light emitting display device, a quantum dot light emitting display device, a plasma display device, and a field emission display device and the like. Hereinafter, as an example of a display device, a case in which an organic light emitting diode display is applied is illustrated, but embodiments according to the present invention are not limited thereto, and the same technical concept may be applied to other display devices if applicable.

The shape of the electronic device 1 may be variously modified. For example, the electronic device 1 may have a shape such as a horizontally long rectangle, a vertically long rectangle, a square, a rectangle with rounded corners (vertexes), other polygons, a circle, an ellipse, or any other suitable shape according to the design of the electronic device 1. The shape of the display area DA of the electronic device 1 may also be similar to the overall shape of the electronic device 1. In FIG. 1, an electronic device 1 having a long rectangular shape in the second direction DR2 is illustrated.

The electronic device 1 may include a display area DA and a non-display area NDA. The display area DA is an area where images may be displayed, and the non-display area NDA is an area where images are not displayed. The display area DA may be referred to as an active area, and the non-display area NDA may also be referred to as a non-active area. The display area DA may generally occupy the center of the electronic device 1. According to some embodiments, the non-display area NDA may surround (e.g., in a periphery or outside a footprint of) the display area DA.

The display area DA may include a first display area DA1, a second display area DA2, and a third display area DA3. The second display area DA2 and the third display area DA3 are areas where components for adding various functions to the electronic device 1 are located, and the second display area DA2 and the third display area DA3 may correspond to a component area.

FIG. 2 is a perspective view illustrating a display device included in an electronic device according to some embodiments.

Referring to FIG. 2, the electronic device (element 1 in FIG. 1) according to some embodiments may include a display device 10. The display device 10 may provide a screen for displaying images by the electronic device 1. The display device 10 may have a planar shape similar to that of the electronic device 1. For example, the display device 10 may have a shape similar to a rectangle having a short side in a first direction DR1 and a long side in a second direction DR2. A corner where the short side of the first direction DR1 and the long side of the second direction DR2 meet may be formed round to have a curvature, but may be formed at a right angle without being limited thereto. The planar shape of the display device 10 is not limited to a rectangle, and may be formed similarly to other polygons, circles, or ellipses, or any other suitable shape in a plan view according to the design of the electronic device 1.

The display device 10 may include a display panel 100, a display driving unit 200, a circuit board 300, and a touch driving unit 400.

The display panel 100 may include a main area MA and a sub-area SBA.

The main area MA may include a display area DA including pixels displaying an image, and the non-display area NDA arranged around (e.g., in a periphery or outside a footprint of) the display area DA. The display area DA may include the first display area DA1, the second display area DA2, and the third display area DA3. The display area DA may emit light from a plurality of emission areas or a plurality of opening areas. For example, the display panel 100 may include a pixel circuit including switching elements, a pixel defining layer defining an emission area or an opening area, and a self-light emitting element.

For example, the self-emitting element may include at least one of an organic light emitting diode (OLED) including an organic light emitting layer, a quantum dot light emitting diode (LED) including a quantum dot light emitting layer, an inorganic light emitting diode (LED) including an inorganic semiconductor, and/or a micro light emitting diode (Micro LED) but embodiments according to the present invention are not limited thereto.

The non-display area NDA may be an area outside the display area DA. The non-display area NDA may be defined as an edge area of the main area MA of the display panel 100. The non-display area NDA may include a gate driving unit supplying gate signals to the gate lines and fan-out lines connecting the display driving unit 200 and the display area DA.

The sub-area SBA may be an area extending from one side of the main area MA. The sub-area SBA may include a flexible material capable of being bent, folded, or rolled, etc. For example, when the sub-area SBA is bent, the sub-area SBA may overlap the main area MA in the thickness direction (third direction DR3). The sub-area SBA may include a pad portion connected to the display driving aunit 200 and the circuit board 300. According to some embodiments, the sub-area SBA may be omitted, and the display driving unit 200 and the pad part may be located in the non-display area NDA.

The display driving unit 200 may output signals and voltages for driving the display panel 100. The display driver 200 may supply data voltages to data lines. The display driving unit 200 may supply a power voltage to the power supply line and may supply a gate control signal to the gate driving unit. The display driving unit 200 may be formed of an integrated circuit (IC) and mounted on the display panel 100 using a chip on glass (COG) method, a chip on plastic (COP) method, or an ultrasonic bonding method. For example, the display driving unit 200 may be located in the sub-area SBA and may overlap the main area MA in the thickness direction by bending the sub-area SBA. For another example, the display driving unit 200 may be mounted on the circuit board 300.

The circuit board 300 may be attached to the pad portion of the display panel 100 using an anisotropic conductive film (ACF). Lead lines of the circuit board 300 may be electrically connected to the pad part of the display panel 100. The circuit board 300 may be a flexible film such as a flexible printed circuit board, a printed circuit board, or a chip on film.

The touch driving unit 400 may be mounted on the circuit board 300. The touch driving unit 400 may be connected to the touch sensing unit of the display panel 100. The touch driving unit 400 may supply a touch driving signal to a plurality of touch electrodes of the touch sensing unit and sense a change in capacitance between the plurality of touch electrodes. For example, the touch driving signal may be a pulse signal having a frequency (e.g., a set or predetermined frequency). The touch driving unit 400 may calculate whether to input and input coordinates based on the capacitance variation between the plurality of touch electrodes. The touch driving unit 400 may be formed of an integrated circuit (IC).

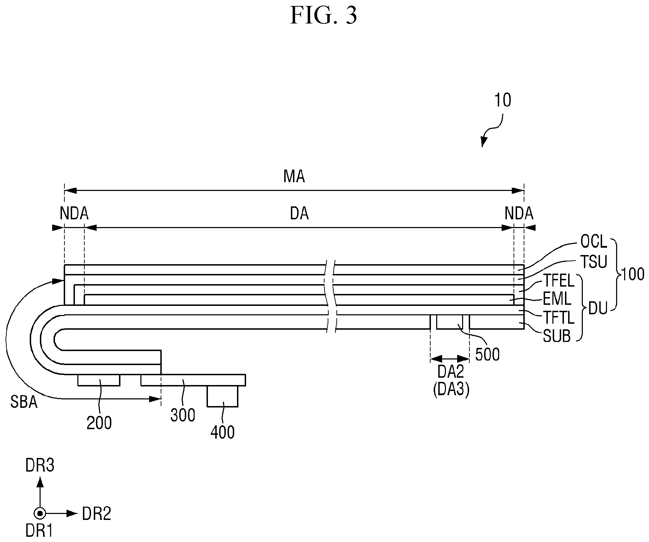

FIG. 3 is a cross-sectional view of the display device of FIG. 2 viewed from the side (e.g., a cross-sectional view).

Referring to FIG. 3, the display panel 100 may include a display layer DU, a touch sensing layer TSU, and a light conversion layer OCL. The display layer DU may include a substrate SUB, a thin film transistor layer TFTL, a light emitting element layer EML, and an encapsulation layer TFEL.

The substrate SUB may be a base substrate or a base member. The substrate SUB may be a flexible substrate capable of being bent, folded, or rolled. For example, the substrate SUB may include a polymer resin such as polyimide (PI) but embodiments according to the present invention are not limited thereto. According to some embodiments, the substrate SUB may include a glass material or a metal material.

The thin film transistor layer TFTL may be located on the substrate SUB. The thin film transistor layer TFTL may include a plurality of thin film transistors constituting pixel circuits of pixels. The thin film transistor layer TFTL may further include gate lines, data lines, power supply lines, gate control lines, fan-out lines connecting the display driving unit 200 and lead lines connecting the display driving unit 200 and the pad unit. Each of the thin film transistors may include a semiconductor region, a source electrode, a drain electrode, and a gate electrode. For example, when the gate driving unit is formed on one side of the non-display area NDA of the display panel 100, the gate driving unit may include thin film transistors.

The thin film transistor layer TFTL may be located in the display area DA, the non-display area NDA, and the sub-area SBA. Thin film transistors, gate lines, data lines, and power supply lines of each of the pixels of the thin film transistor layer TFTL may be located in the display area DA. The gate control lines and fan-out lines of the thin film transistor layer TFTL may be located in the non-display area NDA. The lead lines of the thin film transistor layer TFTL may be located in the sub-area SBA.

The light emitting element layer EML may be located on the thin film transistor layer TFTL. The light emitting element layer EML may include a plurality of light emitting elements including a first electrode, a second electrode, and a light emitting layer that emits light, and a pixel defining layer defining pixels. A plurality of light emitting elements of the light emitting element layer EML may be located in the display area DA.

According to some embodiments, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives a cathode voltage, holes and electrons may be transferred to the organic light emitting layer through the hole transport layer and the electron transport layer, respectively, and may be combined with each other in the organic light emitting layer to emit light.

According to some embodiments, the light emitting element may include a quantum dot light emitting diode including a quantum dot light emitting layer, an inorganic light emitting diode including an inorganic semiconductor, or a micro light emitting diode.

The encapsulation layer TFEL may cover the upper and side surfaces of the light emitting element layer EML and may protect the light emitting element layer EML. The encapsulation layer TFEL may include at least one inorganic layer and at least one organic layer for encapsulating the light emitting element layer EML.

The touch sensing layer TSU may be located on the encapsulation layer TFEL. The touch sensing layer TSU may include a plurality of touch electrodes for detecting user's touch in a capacitive manner and touch lines connecting the plurality of touch electrodes and the touch driving unit 400. For example, the touch sensing layer TSU may sense a user's touch using a mutual capacitance method or a self-capacitance method.

According to some embodiments, the touch sensing layer TSU may be located on a separate substrate located on the display layer DU. In this case, the substrate supporting the touch sensing layer TSU may be a base member sealing the display layer DU.

A plurality of touch electrodes of the touch sensing layer TSU may be in a touch sensor area overlapping the display area DA. The touch lines of the touch sensing layer TSU may be in a touch peripheral area overlapping the non-display area NDA.

The light conversion layer OCL may be on the touch sensing layer TSU. According to some embodiments, the light conversion layer OCL may include a plurality of color filters corresponding to each of a plurality of emission areas. Each of the color filters may selectively transmit light of a specific wavelength and block or absorb light of other wavelengths. The color filter may absorb some of light entered from the outside of the display device 10 to reduce reflected light caused by external light. Accordingly, the color filter may prevent or reduce color distortion due to external light reflection. Because the color filter is directly located on the touch sensing layer TSU, the display device 10 may not require a separate substrate for the color filter. Accordingly, the thickness of the display device 10 may be relatively small.

According to some embodiments, the light conversion layer OCL may include a polarizing film. The polarizing film may be located on the touch sensing layer TSU to prevent or reduce deterioration in visibility due to reflection of external light. The polarizing film may include a phase retardation film such as a linear polarizing plate and a quarter-wave plate (λ/4 plate).

A cover window may be located on the polarizing film. In this case, the polarizing film, and the cover window may be attached by an adhesive material such as optically cleared adhesive film (OCA) or optically cleared resin (OCR).

In some embodiments, the display device 10 may further include an optical device 500. The optical device 500 may be located in the second display area DA2 or the third display area DA3. The optical device 500 may emit or receive light in the infrared, ultraviolet, and visible light bands. For example, the optical device 500 may be an optical sensor that detects light incident on the display device 10, such as a proximity sensor, an illuminance sensor, a camera sensor, or an image sensor.

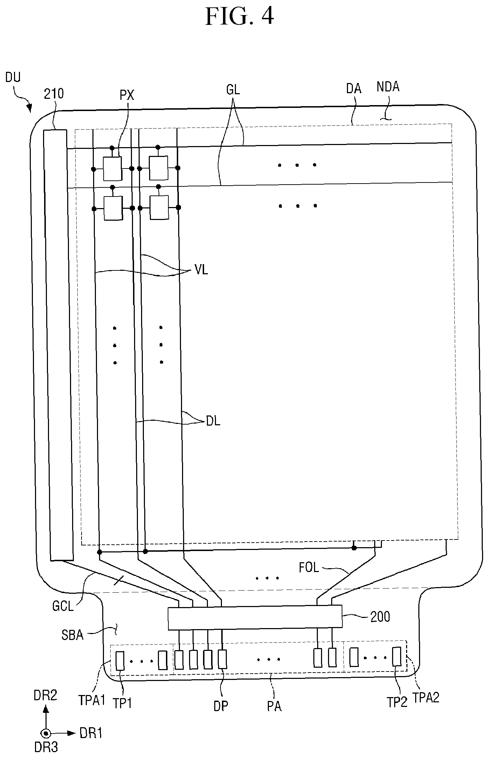

FIG. 4 is a plan view illustrating a display layer of a display device according to some embodiments.

Referring to FIG. 4, the display layer DU may include the display area DA and the non-display area NDA.

The display area DA may be located at the center of the display panel 100. A plurality of pixels PX, a plurality of gate lines GL, a plurality of data lines DL, and a plurality of power supply lines VL may be located in the display area DA. Each of the plurality of pixels PX may be defined as a minimum unit emitting light.

The plurality of gate lines GL may supply the gate signals received from a gate driving unit 210 to the plurality of pixels PX. The plurality of gate lines GL may be extended in the first direction DR1 and may be spaced apart from each other in the second direction DR2 crossing the first direction DR1.

The plurality of data lines DL may supply the data voltages received from the display driving unit 200 to the plurality of pixels PX. The plurality of data lines DL may be extended in the second direction DR2 and may be spaced apart from each other in the first direction DR1.

The plurality of power supply lines VL may supply the power voltage received from the display driving unit 200 to the plurality of pixels PX. Here, the power supply voltage may be at least one of a driving voltage, an initialization voltage, a reference voltage, or a low potential voltage. The plurality of power supply lines VL may be extended in the second direction DR2 and may be spaced apart from each other in the first direction DR1.

The non-display area NDA may surround the display area DA. The gate driving unit 210, fan-out lines FOL, and gate control lines GCL may be located in the non-display area NDA. The gate driving unit 210 may generate a plurality of gate signals based on the gate control signal and may sequentially supply the plurality of gate signals to the plurality of gate lines GL in a set order.

The fan-out lines FOL may be extended from the display driving unit 200 to the display area DA. The fan-out lines FOL may supply the data voltages received from the display driving unit 200 to the plurality of data lines DL.

The gate control line GCL may be extended from the display driving unit 200 to the gate driving unit 210. The gate control line GCL may supply the gate control signal received from the display driving unit 200 to the gate driving unit 210.

The sub-area SBA may include the display driving unit 200, the pad area PA, and first and second touch pad areas TPA1 and TPA2.

The display driving unit 200 may output signals and voltages for driving the display panel 100 to the fan-out lines FOL. The display driving unit 200 may supply the data voltage to the data line DL through the fan-out lines FOL. The data voltage may be supplied to the plurality of pixels PX and may control luminance of the plurality of pixels PX. The display driving unit 200 may supply the gate control signal to the gate driving unit 210 through the gate control line GCL.

The pad area PA, the first touch pad area TPA1, and the second touch pad area TPA2 may be located at edges of the sub-area SBA. The pad area PA, the first touch pad area TPA1, and the second touch pad area TPA2 may be electrically connected to the circuit board 300 by using a material such as the anisotropic conductive film or SAP (Self Assembly Anisotropic Conductive Paste).

The pad area PA may include a plurality of display pad parts DP. The plurality of display pad parts DP may be connected to the graphic system through the circuit board 300. The plurality of display pad parts DP may be in communication with the circuit board 300 to receive digital video data and may supply the digital video data to the display driving unit 200.

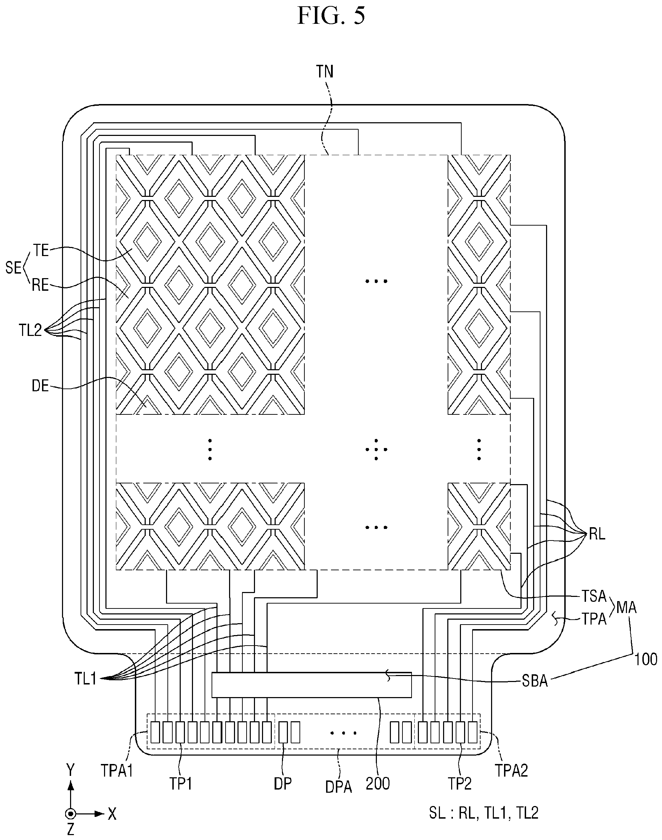

FIG. 5 is a layout diagram illustrating a touch sensing layer in more detail according to some embodiments.

FIG. 5 illustrates the touch sensing unit TSU that includes two types of electrodes, for example, driving electrodes TE and sensing electrodes RE and focuses on a mutual capacitance method in which the touch driving signal is applied to the driving electrodes TE and the sensing electrodes RE detect a change in the charge of the mutual capacitance of each of the plurality of touch nodes TN.

In FIG. 5, only the driving electrodes TE, the sensing electrodes RE, dummy patterns DE, touch lines TL1, TL2, and RL, and the touch pads TP1 and TP2 are illustrated for convenience of explanation.

Referring to FIG. 5, the touch sensing layer TSU includes a touch sensing area TSA for detecting user's touch and a touch peripheral area TPA arranged around the touch sensing area TSA. The touch sensing area TSA may overlap the display area (DA of FIGS. 1 and 2), and the touch peripheral area TPA may overlap the non-display area (NDA of FIGS. 1 and 2).

The touch sensing area TSA includes driving electrodes TE, sensing electrodes RE, and dummy patterns DE. The driving electrodes TE and the sensing electrodes RE may be electrodes for forming mutual capacitance to sense a detect of an object or human touch.

The sensing electrodes RE may be arranged in parallel in a first direction (X-axis direction) and a second direction (Y-axis direction). The sensing electrodes RE may be electrically connected in the first direction (X-axis direction). In the first direction (X-axis direction), adjacent sensing electrodes RE may be connected to each other. In the second direction (Y-axis direction), adjacent sensing electrodes RE may be electrically separated from each other. For this reason, a touch node TN in which mutual capacitance is formed may be located at each intersection of the driving electrodes TE and the sensing electrodes RE. The plurality of touch nodes TN may correspond to intersections of the driving electrodes TE and the sensing electrodes RE.

The driving electrodes TE may be arranged in parallel in the first direction (X-axis direction) and the second direction (Y-axis direction). Driving electrodes TE adjacent to each other in the first direction (X-axis direction) may be electrically separated from each other. The driving electrodes TE may be electrically connected in the second direction (Y-axis direction). For example, adjacent driving electrodes TE in the second direction (Y-axis direction) may be connected to each other through a first connection electrode BE1 as shown in FIG. 5.

Each of the dummy patterns DE may be surrounded by the driving electrode TE or the sensing electrode RE. Each of the dummy patterns DE may be electrically separated from the driving electrode TE or the sensing electrode RE. Each of the dummy patterns DE may be spaced apart from the driving electrode TE or the sensing electrode RE. Each of the dummy patterns DE may be electrically floated.

Although FIG. 5 illustrates that each of the driving electrodes TE, the sensing electrodes RE, and the dummy patterns DE have a rhombic planar shape, present specification is not limited thereto. For example, each of the driving electrodes TE, the sensing electrodes RE, and the dummy patterns DE may have a planar shape such as a rectangle other than a rhombus, a polygon other than a rectangle, a circle, or an ellipse.

The touch lines TL1, TL2, and RL may be located in the sensor peripheral area TPA. The touch lines TL1, TL2, and RL include touch sensing lines RL connected to the sensing electrodes RE and first touch driving lines TL1 and second touch driving lines TL2 connected to the driving electrodes TE.

The sensing electrodes RE located on one side of the touch sensing area TSA may be connected to the touch sensing lines RL one-to-one. For example, as shown in FIG. 5, among the sensing electrodes RE electrically connected in the first direction (X-axis direction), the sensing electrode RE located at the right end may be connected to the touch sensing line RL. The touch sensing lines RL may be connected to the second touch pads TP2 one-to-one. Therefore, the touch driving circuit (400 in FIG. 2) may be electrically connected to the sensing electrodes RE.

The driving electrodes TE located on one side of the touch sensing area TSA are connected to the first touch driving lines TL1 in one-to-one, and the driving electrodes TE located on the other side of the touch sensing area TSA may be connected to the second touch driving lines TL2 one-to-one. For example, as shown in FIG. 5, among the driving electrodes TE electrically connected in the second direction (Y-axis direction), the driving electrode TE located at the lower end is connected to the first touch driving line TL1, and the driving electrode TE located at the upper end may be connected to the second touch driving line TL2. The second touch driving lines TL2 may be connected to the driving electrodes TE on the upper side of the touch sensing area TSA via the left outer side of the touch sensing area TSA.

The first touch driving lines TL1 and the second touch driving lines TL2 may be connected to the first touch pads TP1 one-to-one. Therefore, the touch driving circuit 400 may be electrically connected to the driving electrodes TE. Because the driving electrodes TE are connected to the driving lines TL1 and TL2 at both sides of the touch sensing area TSA to receive the touch driving signal, the RC delay of the touch driving signals may prevent or reduce a difference between the touch driving signals applied to the driving electrodes TE located on the lower side of the touch sensing area TSA and the touch driving signals applied to the driving electrodes TE located on the upper side of the touch sensing area TSA.

The first touch pad area TPA1 on which the first touch pads TP1 are located may be located on one side of the display pad area DPA on which the display pads DP are located. The second touch pad area TPA2 on which the second touch pads TP2 are located may be located on the other side of the display pad area DPA. The display pads DP may be electrically connected to data lines of the display panel 100.

The display pad area DPA, the first touch pad area TPA1, and the second touch pad area TPA2 may correspond to pads of the display panel 100 connected to the circuit board 300 shown in FIG. 2. The circuit board 300 may be located on the display pads DP, the first touch pad area TPA1, and the second touch pad area TPA2. The display pad area DPA, the first touch pad area TPA1, and the second touch pad area TPA2 may be electrically connected to the circuit board 300 through the anisotropic conductive film and a conductive adhesive member. Therefore, the display pad area DPA, the first touch pad area TPA1, and the second touch pad area TPA2 may be electrically connected to the touch driving circuit 400 located on the circuit board 300.

Although FIG. 5 illustrates that the second display area DA2 does not overlap the driving electrodes TE and the sensing electrodes RE for convenience of explanation, the present specification is not limited thereto. For example, the third display area DA3 may not overlap the driving electrodes TE and the sensing electrodes RE.

Because the driving electrodes TE and the sensing electrodes RE do not overlap the second display area DA2, the driving electrodes TE adjacent to the second display area DA2 may have a different planar shape than the driving electrodes TE not adjacent to the second display area DA2. Also, an area of each of the driving electrodes TE adjacent to the second display area DA2 may be smaller than an area of each of the driving electrodes TE not adjacent to the second display area DA2.

In addition, because the sensing electrodes RE do not overlap the second display area DA2, the sensing electrodes RE adjacent to the second display area DA2 may have a different planar shape than the sensing electrodes RE not adjacent to the second display area DA2. An area of each of the sensing electrodes RE adjacent to the second display area DA2 may be smaller than an area of each of the sensing electrodes RE not adjacent to the second display area DA2.

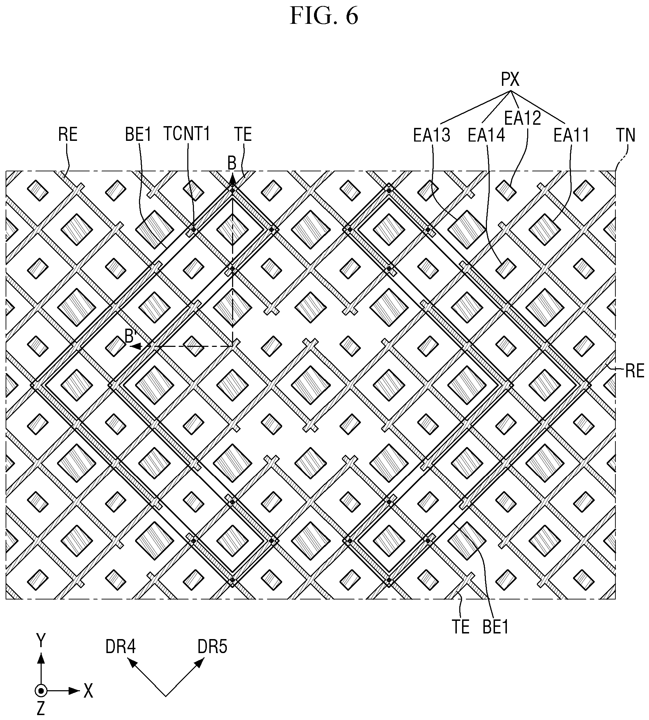

FIG. 6 is a layout diagram illustrating an example of the touch node of FIG. 5 in detail.

Referring to FIG. 6, the touch node TN may be defined as an intersection of driving electrodes TE and sensing electrodes RE.

Because the driving electrodes TE and the sensing electrodes RE are located on the same layer, they may be spaced apart from each other. That is, a gap may be formed between the driving electrode TE and the sensing electrode RE adjacent to each other.

In addition, the dummy pattern DE may be located on the same layer as the driving electrodes TE and the sensing electrodes RE. That is, a gap may be formed between the driving electrode TE and the dummy pattern DE, which are adjacent to each other, and between the sensing electrode RE and the dummy pattern DE, which are adjacent to each other.

The first connection electrodes BE1 may be located on a different layer from the driving electrodes TE and sensing electrodes RE. The first connection electrode BE1 may be bent at least once. In FIG. 5, the first connection electrode BE1 has an angle bracket shape ("<" or ">"), but the planar shape of the first connection electrode BE1 is not limited thereto. Because the driving electrodes TE adjacent to each other in the second direction (Y-axis direction) are connected by the plurality of first connection electrodes BE1, driving electrodes TE adjacent to each other in the second direction (Y-axis direction) may be stably connected even if one of the plurality of first connection electrodes BE1 is disconnected. Although FIG. 6 illustrates that adjacent driving electrodes TE are connected by two first connection electrodes BE1, the number of first connection electrodes BE1 is not limited thereto.

The first connection electrode BE1 may overlap adjacent driving electrodes TE in the second direction (Y-axis direction) in the third direction (Z-axis direction), which is the thickness direction of the substrate SUB. The first connection electrode BE1 may overlap the sensing electrode RE in the third direction (Z-axis direction). One side of the first connection electrode BE1 may be connected to one of adjacent driving electrodes TE in the second direction (Y-axis direction) through a first touch contact hole TCNT1. The other side of the first connection electrode BE1 may be connected to another driving electrode TE among adjacent driving electrodes TE in the second direction (Y-axis direction) through the first touch contact hole TCNT1.

The driving electrodes TE and the sensing electrodes RE may be electrically separated from each other at their intersections due to the plurality of first connection electrodes BE1. As a result, mutual capacitance may be formed between the driving electrodes TE and the sensing electrodes RE.

Each of the driving electrodes TE, sensing electrodes RE, and first connection electrode BE1 may have a mesh structure or a planar shape of a mesh structure. Also, each of the dummy patterns DE may have a mesh structure or a planar shape of a mesh structure. As a result, each of the driving electrodes TE, the sensing electrodes RE, the first connection electrodes BE1, and the dummy patterns DE may not overlap with each of the light light emitting units EA1, EA2, EA3, and EA4 of the first pixel PX1. Therefore, the light emitted from the light emitting units EA1, EA2, EA3, and EA4 may be blocked by the driving electrode TE, the sensing electrodes RE, the first connection electrodes BE1, and the dummy patterns DE, thereby preventing or reducing a decrease in the luminance of the light.

Each of the first pixels PX1 includes a first light emitting area EA11 emitting light of a first color, a second light emitting area EA12 emitting light of a second color, a third light emitting area EA13 emitting light of a third color, and a fourth light emitting area EA14 emitting light of a second color. For example, the first color may be red, the second color may be green, and the third color may be blue. Although FIG. 6 illustrates that the second light emitting area EA12 and the fourth light emitting area EA14 of the first pixel PX1 emit the same color, the present specification is not limited thereto. That is, the second light emitting area EA12 and the fourth light emitting area EA14 of the first pixel PX1 may emit light of different colors.

The first light emitting area EA11 and the second light emitting area EA12 of each of the first pixels PX1 may be adjacent to each other in the fourth direction DR4, and the third light emitting area EA13 and the fourth light emitting area EA14 may be adjacent to each other in the fourth direction DR4. The first light emitting area EA11 and the fourth light emitting area EA14 of each of the first pixels PX1 may be adjacent to each other in the fifth direction DR5, and the second light emitting area EA12 and the third light emitting area EA13 may be adjacent to each other in the fifth direction DR5.

Each of the first light emitting area EA11, the second light emitting area EA12, the third light emitting area EA13, and the fourth light emitting area EA14 may have a rhombic or rectangular planar shape but is not limited thereto. Each of the first light emitting area EA11, the second light emitting area EA12, the third light emitting area EA13, and the fourth light emitting area EA14 may have a polygonal, circular, or elliptical planar shape other than a rectangle. Also, although FIG. 6 illustrates that the area of the third light emitting area EA13 is the largest and the areas of the second light emitting area EA12 and the fourth light emitting area EA14 are the smallest, it is not limited thereto.

The second light emitting areas EA12 and the fourth light emitting areas EA14 may be located in odd-numbered rows. The second light emitting areas EA12 and the fourth light emitting areas EA14 may be arranged side by side in the first direction (X-axis direction) in each of odd-numbered rows. The second light emitting areas EA12 and the fourth light emitting areas EA14 may be alternately arranged in each odd-numbered row. Each of the second light emitting areas EA12 has a short side in the fourth direction DR4 and a long side in the fifth direction DR5, while each of the fourth light emitting areas EA14 may have a long side in the fourth direction DR4 and a short side in the fifth direction DR5. The fourth direction DR4 is a direction between the first direction (X-axis direction) and the second direction (Y-axis direction), which may be a direction inclined at 45 degrees relative to the first direction (X-axis direction). The fifth direction DR5 may be a direction perpendicular to the fourth direction DR4.

The first light emitting areas EA11 and the third light emitting areas EA13 may be located in even rows. The first light emitting uni areas ts EA11 and the third light emitting areas EA13 may be arranged side by side in the first direction (X-axis direction) in each of the even rows. The first light emitting areas EA11 and the third light emitting areas EA13 may be alternately located in each of the even rows.

The second light emitting areas EA12 and the fourth light emitting areas EA14 may be located in odd-numbered columns. The second light emitting areas EA12 and the fourth light emitting areas EA14 may be arranged side by side in the second direction (Y-axis direction) in each of the odd-numbered columns. The second light emitting areas EA12 and the fourth light emitting areas EA14 may be alternately located in each of odd-numbered columns.

The first light emitting areas EA11 and the third light emitting areas EA13 may be arranged in even-numbered columns. The first light emitting areas EA11 and the third light emitting areas EA13 may be arranged side by side in the second direction (Y-axis direction) in each of the even-numbered columns. The first light emitting areas EA11 and the third light emitting areas EA13 may be alternately located in each of the even-numbered columns.

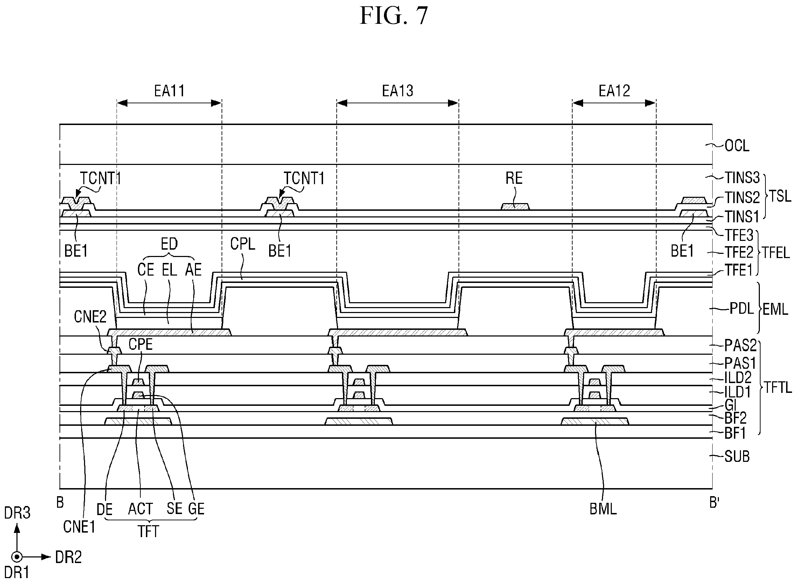

FIG. 7 is a cross-sectional view illustrating an example of a display panel taken along B-B' of FIG. 6.

Referring to FIG. 7, the thin film transistor layer TFTL may be located on the substrate SUB.

The thin film transistor layer TFTL may include a first buffer layer BF1, a bottom metal layer BML, a second buffer layer BF2, a thin film transistor TFT, a gate insulating layer GI, a first interlayer insulating layer ILD1, and a capacitor electrode CPE, a second interlayer insulating layer ILD2, a first connection electrode CNE1, a first protective layer PAS1, a second connection electrode CNE2, and second protective layer PAS2.

The first buffer layer BF1 may be located on the substrate SUB. The first buffer layer BF1 may include an inorganic layer capable of preventing or reducing penetration of air or moisture. For example, the first buffer layer BF1 may include a plurality of stacked inorganic films.

The bottom metal layer BML may be located on the first buffer layer BF1. For example, the bottom metal layer BML may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

The second buffer layer BF2 may cover the first buffer layer BF1 and the bottom metal layer BML. The second buffer layer BF2 may include an inorganic layer capable of preventing or reducing penetration of air, moisture, or other contaminants. For example, the second buffer layer BF2 may include a plurality of stacked inorganic films.

The thin film transistor TFT may be located on the second buffer layer BF2 and constitute a pixel circuit of each of a plurality of pixels. For example, the thin film transistor TFT may be a driving transistor or a switching transistor of a pixel circuit. The thin film transistor TFT may include a semiconductor layer ACT, a source electrode SE, a drain electrode DE, and a gate electrode GE.

The semiconductor layer ACT may be located on the second buffer layer BF2. The semiconductor layer ACT may overlap the bottom metal layer BML and the gate electrode GE in a thickness direction and may be insulated from the gate electrode GE by the gate insulating layer GI. In a portion of the semiconductor layer ACT, a material of the semiconductor layer ACT may be conductive to form the source electrode SE and the drain electrode DE.

The gate electrode GE may be located on the gate insulating layer GI. The gate electrode GE may overlap the semiconductor layer ACT with the gate insulating layer GI interposed therebetween.

The gate insulating layer GI may be located on the semiconductor layer ACT. For example, the gate insulating layer GI may cover the semiconductor layer ACT and the second buffer layer BF2 and may insulate the semiconductor layer ACT and the gate electrode GE. The gate insulating layer GI may include a contact hole through which the first connection electrode CNE1 penetrates.

The first interlayer insulating layer ILD1 may cover the gate electrode GE and the gate insulating layer GI. The first interlayer insulating layer ILD1 may include the contact hole through which the first connection electrode CNE1 penetrates. The contact hole of the first interlayer insulating layer ILD1 may be connected to the contact hole of the gate insulating layer GI and the contact hole of the second interlayer insulating layer ILD2.

The capacitor electrode CPE may be located on the first interlayer insulating layer ILD1. The capacitor electrode CPE may overlap the gate electrode GE in the thickness direction. The capacitor electrode CPE and the gate electrode GE may form a capacitance.

The second interlayer insulating layer ILD2 may cover the capacitor electrode CPE and the first interlayer insulating layer ILD1. The second interlayer insulating layer ILD2 may include the contact hole through which the first connection electrode CNE1 penetrates. The contact hole of the second interlayer insulating layer ILD2 may be connected to the contact hole of the first interlayer insulating layer ILD1 and the contact hole of the gate insulating layer GI.

The first connection electrode CNE1 may be located on the second interlayer insulating layer ILD2. The first connection electrode CNE1 may electrically connect the drain electrode DE of the thin film transistor TFT and the second connection electrode CNE2. The first connection electrode CNE1 is inserted into the contact hole formed in the second interlayer insulating layer ILD2, the first interlayer insulating layer ILD1, and the gate insulating layer GI, and may contact the drain electrode DE of the thin film transistor TFT.

The first protective layer PAS1 may cover the first connection electrode CNE1 and the second interlayer insulating layer ILD2. The first protective layer PAS1 may protect the thin film transistor TFT. The first protective layer PAS1 may include the contact hole through which the second connection electrode CNE2 penetrates.

The second connection electrode CNE2 may be located on the first protective layer PAS1. The second connection electrode CNE2 may electrically connect the first connection electrode CNE1 and a pixel electrode AE of the light emitting element ED. The second connection electrode CNE2 may be inserted into the contact hole formed in the first protective layer PAS1 to make contact with the first connection electrode CNE1.

The second protective layer PAS2 may cover the second connection electrode CNE2 and the first protective layer PAS1. The second protective layer PAS2 may include the contact hole through which the pixel electrode AE of a light emitting element ED penetrates.

The light emitting element layer EML may be located on the thin film transistor layer TFTL. The light emitting layer EML may include the light emitting element ED and a pixel defining layer PDL. The light emitting element ED may include the pixel electrode AE, a light emitting layer EL, and a common electrode CE.

The pixel electrode AE may be located on the second protective layer PAS2. The pixel electrode AE may be arranged to overlap one of the opening units OPE1, OPE2, and OPE3 of the pixel defining layer PDL. The pixel electrode AE may be electrically connected to the drain electrode DE of the thin film transistor TFT through the first and second connection electrodes CNE1 and CNE2.

The light emitting layer EL may be located on the pixel electrode AE. For example, the light emitting layer EL may be an organic light emitting layer made of an organic material but is not limited thereto. When the light emitting layer EL corresponds to the organic light emitting layer, the thin film transistor TFT applies a voltage (e.g., a set or predetermined voltage) to the pixel electrode AE of the light emitting element ED. Then, the common electrode CE of the light emitting element ED receives a common voltage or a cathode voltage, holes and electrons may move to the light emitting layer EL through the hole transport layer and the electron transport layer, respectively, and holes and electrons may be combined with each other in the light emitting layer EL to emit light.

The common electrode CE may be located on the light emitting layer EL. For example, the common electrode CE may be implemented in the form of an electrode common to all pixels, not differentiated by a plurality of pixels. The common electrode CE may be located on the light emitting layer EL in the first to third light emitting areas EA1, EA2, and EA3, and may be located on the pixel defining layer PDL in areas other than the first to third light emitting areas EA1, EA2, and EA3.

In the top light emitting structure, the common electrode CE may be formed of a transparent conductive material (TCO) such as ITO or IZO that may transmit light, or a semi-transmissive conductive material such as magnesium (Mg), silver (Ag), or an alloy of magnesium (Mg) and silver (Ag). When the common electrode CE is formed of a transflective metal material, light emission efficiency may be increased by a micro cavity.

The common electrode CE may receive a common voltage or a low potential voltage. When the pixel electrode AE receives the voltage corresponding to the data voltage and the common electrode CE receives the low potential voltage, a potential difference is formed between the pixel electrode AE and the common electrode CE, thereby enabling the light emitting layer EL to emit light.

The pixel defining layer PDL may be located on a portion of the second protective layer PAS2 and the pixel electrode AE. The pixel defining layer PDL may define the first to third light emitting areas EA1, EA2, and EA3, and their areas or sizes may be different from each other. The pixel defining layer PDL may separate and insulate the pixel electrode AE of each of the plurality of light emitting elements ED. The pixel defining layer PDL may include a light absorbing material to prevent or reduce light reflection. For example, the pixel defining layer PDL may include a polyimide (PI)-based binder and pigments in which red, green, and blue colors are mixed. Alternatively, the pixel defining layer PDL may include a cardo-based binder resin and a mixture of lactam-based black pigment and blue pigment. Alternatively, the pixel defining layer PDL may include carbon black.

A capping layer CPL may be located on the common electrode CE. The capping layer CPL may include at least one inorganic layer to prevent or reduce instances of oxygen, moisture, or other contaminants penetrating into the light emitting element layer EML. According to some embodiments, the capping layer CPL may include aluminum oxide, titanium oxide, tantalum oxide, hafnium oxide, zinc oxide, silicon oxide, silicon nitride, and/or silicon oxynitride.

The thin film encapsulation layer TFEL may be located on the capping layer CPL to cover the plurality of light emitting elements ED. The thin film encapsulation layer TFEL may include at least one inorganic layer to prevent or reduce instances of oxygen, moisture, or other contaminants penetrating into the light emitting element layer EML. The thin film encapsulation layer TFEL may include at least one organic layer to protect the light emitting element layer EML from foreign substances such as dust.

According to some embodiments, the thin film encapsulation layer TFEL may include a first encapsulation layer TFEL1, a second encapsulation layer TFEL2, and a third encapsulation layer TFEL3. The first encapsulation layer TFEL1 and the third encapsulation layer TFEL3 may be inorganic encapsulation layers, and the second encapsulation layer TFEL2 located between them may be an organic encapsulation layer.

Each of the first encapsulation layer TFEL1 and the third encapsulation layer TFEL3 may include one or more inorganic insulators. The inorganic insulator may include aluminum oxide, titanium oxide, tantalum oxide, hafnium oxide, zinc oxide, silicon oxide, silicon nitride, and/or silicon oxynitride.

The second encapsulation layer TFEL2 may include a polymer-based material. Polymer-based materials may include acrylic resins, epoxy resins, polyimide, and polyethylene. For example, the second encapsulation layer TFEL2 may include an acrylic resin such as polymethyl methacrylate or polyacrylic acid. The second encapsulation layer TFEL2 may be formed by curing a monomer or applying a polymer. The second encapsulation layer TFEL2 may serve as a planarization.

The touch sensing layer TSU may be located on the encapsulation layer TFEL. The touch sensing layer TSU includes a first touch insulating film TINS1, a first connection electrode BE1, a second touch insulating film TINS2, a driving electrode TE, a sensing electrode RE, and a third touch insulating film TINS3.

The first touch insulating film TINS1 may be formed of an inorganic layer, such as a silicon nitride layer, a silicon oxynitride layer, a silicon oxide layer, a titanium oxide layer, or an aluminum oxide layer.

The first connection electrode BE1 may be located on the first touch insulating film TINS1. The first connection electrode BE1 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

The second touch insulating film TINS2 is located on the first connection electrode BE1. The second touch insulating layer TINS2 may be formed of an inorganic layer, for example, a silicon nitride layer, a silicon oxynitride layer, a silicon oxide layer, a titanium oxide layer, or an aluminum oxide layer. Alternatively, the second touch insulating film TINS2 may be formed from an organic film such as acrylic resin, epoxy resin, phenolic resin, polyamide resin, or polyimide resin.

Driving electrodes TE and sensing electrodes RE may be located on the second touch insulating film TINS2. Also, not only the driving electrodes TE and the sensing electrodes RE, but also the dummy patterns DE, the first touch driving lines TL1, the second touch driving lines TL2, and touch sensing lines RL shown in FIG. 4 may be located on the second touch insulating film TINS2. The driving electrodes TE and the sensing electrodes RE may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

The driving electrode TE and the sensing electrode RE may overlap the first connection electrode BE1 in the third direction (Z-axis direction). The driving electrode TE may be connected to the first connection electrode BE1 through the first touch contact hole TCNT1 penetrating the first touch insulating film TINS1.

The third touch insulating film TINS3 is formed on the driving electrodes TE and the sensing electrodes RE. The third touch insulating film TINS3 may serve to flatten a step formed by the driving electrodes TE, the sensing electrodes RE, and the first connection electrode BE1. The third touch insulating film TINS3 may be formed of an organic film such as acrylic resin, epoxy resin, phenolic resin, polyamide resin, or polyimide resin.

The light conversion layer OCL may be located on the touch sensing layer TSU.

As such, the touch sensitivity of the touch sensing layer TSU may decrease due to the base capacitance of the second encapsulation layer TFEL2.

For touch sensitivity, it may be inversely proportional to the thickness of the second encapsulation layer TFEL2 and proportional to the permittivity of the second encapsulation layer TFEL2. Therefore, a method of increasing the thickness of the second encapsulation layer TFEL2 and a method of lowering the permittivity of the second encapsulation layer TFEL2 may be considered to reduce the base capacitance value.

However, when the thickness of the second encapsulation layer TFEL2 is increased, frontal transmittance of light emitted from the light emitting element layer EML may decrease.

Therefore, it may be desirable to lower the dielectric constant of the second encapsulation layer TFEL2 and simultaneously (or concurrently) lower the thickness of the second encapsulation layer TFEL2 to reduce the base capacitance value of the second encapsulation layer TFEL2 while maintaining the frontal transmittance of the light emitted from the light emitting element layer EML at an appropriate level.

According to some embodiments, the dielectric constant of the second encapsulation layer TFEL2 may be about 2.0 to about 3.0 or less, and the thickness of the second encapsulation layer TFEL2 may be 8 µm to 9 µm or 10 µm to 11 µm. For example, the dielectric constant of the second encapsulation layer TFEL2 may be 2.5, and the thickness of the second encapsulation layer TFEL2 may be 8.8 µm.

Meanwhile, as a method of adjusting the thickness of the second encapsulation layer TFEL2 to improve the frontal transmittance of light emitted from the light emitting element layer EML, a method of adjusting the spacing between the nozzles applying the organic material of the second encapsulation layer TFEL2 may be considered. However, in this process, the spread of the organic material may be poor. When the spreadability of the organic material is poor, the uniformity of the second encapsulation layer TFEL2 is deteriorated, and at the same time, stain defects may be caused on the display surface.

An inorganic insulating layer having a refractive index similar to that of the second encapsulation layer TFEL2 may be added to the lower surface of the second encapsulation layer TFEL2 to improve the spreadability of the organic material.

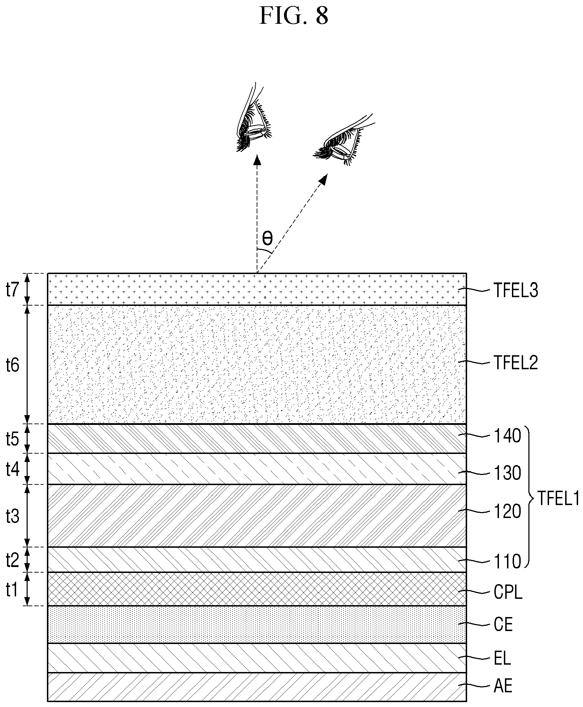

FIG. 8 is a cross-sectional view illustrating a stacked structure of a light emitting element and an encapsulation layer of a display device according to some embodiments in more detail.

Referring to FIG. 8, the display device 10 may include a structure in which a light emitting element ED and a plurality of inorganic or organic layers located thereon are stacked. For example, the display device 10 may include the capping layer CPL, the first encapsulation layer TFEL1, the second encapsulation layer TFEL2, and the thrid encapsulation layer TFEL3 sequentially arranged on the common electrode CE of the light emitting element ED. The capping layer CPL located directly on the light emitting element ED may include an inorganic insulating material. Light emitted from the light emitting element ED passes through the capping layer CPL and the first encapsulation layer TFEL1, which may include multiple layers with different refractive indices. As the capping layer CPL and the multilayer first encapsulation layer TFEL1 have different refractive indices, reflection of light may occur at the interface between them. The display device 10 arranges optical layers capable of reflecting light on the light emitting element ED using layers having different refractive indices, so that light efficiency (or light emission efficiency) and viewing angle characteristics of the light emitting element ED are desired.

According to some embodiments, in the display device 10, the first encapsulation layer TFEL1 may include a plurality of inorganic insulating layers 110, 120, 130, and 140. The plurality of inorganic insulating layers 110, 120, 130, and 140 may include an optical layer 110, a moisture barrier layer 120, an auxiliary layer 130, and an upper layer 140.

The optical layer 110 may function as an optical layer by reflecting light at an interface therebetween. The first encapsulation layer TFEL1 may include the optical layer 110, the moisture barrier layer 120, the auxiliary layer 130, and the upper layer 140 sequentially arranged on the capping layer CPL. Layers sequentially arranged from the capping layer CPL to the upper layer 140 may include different materials and may have different refractive indices and thicknesses. The light emitted from the light emitting element ED is emitted in an upward direction from the capping layer CPL through the upper layer 140, and the light may be partially reflected and refracted as it passes through the interfaces of the layers having different refractive indices. By adjusting the refractive index and thickness of each layer located on the light emitting element ED, light emission efficiency and viewing angle characteristics of light emitted from the light emitting element ED may be controlled to desired conditions.

Hereinafter, as the optical layers located on the light emitting element ED, the capping layer CPL and the plurality of inorganic insulating layers 110, 120, 130, and 140 of the first encapsulation layer TFEL1 will be described.

The capping layer CPL may include at least one of silicon oxide (SiOx), silicon nitride (SiNx), or silicon oxynitride (SiOxNy). The capping layer CPL may have a refractive index n1 of 1.60 to 2.30 and a thickness t1 of 50 nm (500 Å) to 150 nm (1500 Å). For example, the capping layer CPL may have a refractive index n1 of 2.0 and a thickness t1 of 60 nm (600 Å).

According to some embodiments, in the display device 10, a plurality of inorganic insulating layers located on the capping layer CPL may include an insulating layer having a relatively high refractive index and an insulating layer having a relatively low refractive index. Among the plurality of inorganic insulating layers, inorganic insulating layers arranged to contact each other may have different refractive indices. The plurality of inorganic insulating layers may have a structure in which an inorganic insulating layer having a high refractive index and an inorganic insulating layer having a low refractive index are stacked on each other. For example, the capping layer CPL may be a high refractive index layer having a relatively high refractive index, the optical layer 110 of the first encapsulation layer TFEL1 may be a low refractive index layer, and the moisture barrier layer 120 may be a high refractive index layer. The auxiliary layer 130 may be a medium refractive layer having a refractive index between the optical layer 110 and the moisture barrier layer 120.

The optical layer 110 may include at least one of silicon oxide (SiOx), silicon nitride (SiNx), or silicon oxynitride (SiOxNy). The optical layer 110 may be located on the capping layer CPL and may have a lower refractive index than the capping layer CPL. For example, the optical layer 110 may have a refractive index n2 of 1.20 to 1.62 and a thickness t2 of 40 nm (400 Å) to 200 nm (2000 Å). According to some embodiments, the optical layer 110 may include silicon oxynitride (SiOxNy), have a refractive index n2 of 1.57, and have a thickness t2 of 110 nm (1100 Å).

The capping layer CPL and the optical layer 110 described above may be layers that have a major effect on the optical characteristics of the display device 10. The thickness and refractive index of the layers may need to be precisely controlled to achieve resonance characteristics for each target wavelength. Ranges of thicknesses and refractive indices of each layer may be ranges designed to have optical characteristics targeted by the display device 10.

The moisture barrier layer 120 may include at least one of silicon oxide (SiOx), silicon nitride (SiNx), or silicon oxynitride (SiOxNy). The moisture barrier layer 120 may be located on the optical layer 110 and have a higher refractive index than the optical layer 110. For example, the moisture barrier layer 120 may have a refractive index n3 of 1.70 to 1.90 and a thickness t3 of 400 nm (4000 Å) to 900 nm (9000 Å). According to some embodiments, the moisture barrier layer 120 may include silicon nitride (SiNx), have a refractive index n3 of 1.89, and have a thickness t3 of 900 nm (9000 Å).

The moisture barrier layer 120 may be a layer that has relatively little effect on optical characteristics in the first encapsulation layer TFEL1 and may be a layer for securing reliability such as moisture vapor transmission and oxidation prevention or reduction. Accordingly, the moisture barrier layer 120 may have a relatively large thickness (t4, 400 nm (4000 Å) or more).

The auxiliary layer 130 may include at least one of silicon oxide (SiOx), silicon nitride (SiNx), or silicon oxynitride (SiOxNy). The auxiliary layer 130 is located on the moisture barrier layer 120 and may have a smaller refractive index than the moisture barrier layer 120. For example, the auxiliary layer 130 may have a refractive index n4 of 1.50 to 1.80 and a thickness t4 of 60 nm (600 Å) to 140 nm (1400 Å). According to some embodiments, the auxiliary layer 130 may include silicon oxynitride (SiOxNy), have a refractive index n4 of 1.70, and have a thickness t4 of 65 nm (650 Å).

The light generated by the film thickness distribution of the optical layer 110 is destructively interfered with the light of the auxiliary layer 130 to further reduce the distribution of movement traces in the color temperature direction on color coordinates.

The upper layer 140 is located on the auxiliary layer 130. The upper layer 140 may include at least one of O-rich silicon oxide (SiOx), silicon nitride (SiNx), or silicon oxynitride (SiOxNy). According to some embodiments, the upper layer 140 may include O-rich SiOxNy. For example, the upper layer 140 may have a refractive index n5 of 1.50 to 1.80 and a thickness t5 of 60 nm (600 Å) to 140 nm (1400 Å). The upper layer 140 may have a refractive index n5 of 1.50 and a thickness t5 of 80 nm (800 Å).

The upper layer 140 may not have moisture permeability. The upper layer 140 may control the material constituting the organic encapsulation layer 320 during the process of the second encapsulation layer TFEL2 formed by coating and curing the monomer.

As described above, the upper layer 140 may not have moisture permeability and may not separately have an optical function, and the refractive index of the upper layer 140 may be substantially the same as that of the second encapsulation layer TFEL2. When the refractive index of the upper layer 140 and the refractive index of the second encapsulation layer TFEL2 are substantially the same, it means that the difference between the refractive indices of the upper layer 140 is less than 0.05.

The second encapsulation layer TFEL2 may be an organic insulating layer. The second encapsulation layer TFEL2 may have a refractive index n6 of 2.0 to 3.1 and a thickness t6 of 8 µm to 12 µm. According to some embodiments, the second encapsulation layer TFEL2 may have a refractive index n6 of 1.5 and a thickness t6 of 8.8 µm or 11 µm. The second encapsulation layer TFEL2 may have a permittivity of 3.1 or less. According to some embodiments, the second encapsulation layer TFEL2 may have a permittivity of 3.1 or 2.5.

The third encapsulation layer TFEL3 may include at least one of silicon oxide (SiOx), silicon nitride (SiNx), or silicon oxynitride (SiOxNy). The third encapsulation layer TFEL3 may have a refractive index n7 of 1.89 and a thickness t7 of 500 nm (5000 Å).

In the display device 10, the thickness of the plurality of inorganic insulating layers 110, 120, 130, and 140 of the capping layer CPL, the first encapsulation layer TFEL1, and the plurality of mineral insulating layers 110, 120, 130, 140 may be designed in a specific range depending on optical characteristics, reliability, and TACT time, etc. In the inorganic insulating layer, as the refractive index is high and the thickness is thick, reliability characteristics due to moisture permeability are improved, but the TACT time may increase, the optical absorption may increase, and the thickness distribution may increase. In particular, when the optical cavity length is increased, it may be difficult to secure resonance characteristics as the optical path is longer than the coherent length or a high-order resonance is used. Furthermore, because the final optical characteristics vary according to the spectrum of light as light passes through the plurality of layers in the display device 10, fine adjustment of the thickness and refractive index of the inorganic insulating layer may be required to adjust the resonance characteristics for each wavelength depending on the material of the inorganic insulating layer.

The display device 10 has a structure in which the capping layer CPL, the optical layer 110, and the moisture barrier layer 120 are sequentially stacked, and layers having high and low refractive indices may be stacked from the capping layer CPL to the moisture barrier layer 120. As a plurality of layers having different refractive indices are sequentially stacked, an interface capable of refracting or reflecting light may be formed at the interface of the capping layer CPL, the optical layer 110, and the moisture barrier layer 120 arranged against each other. In particular, the optical layer 110 and the moisture barrier layer 120 may have different refractive indices, including silicon oxynitride (SiOxNy) and silicon nitride (SiNx), respectively, to form a plurality of reflective interfaces with the capping layer CPL. The display device 10 according to some embodiments includes a stacked structure of layers having different refractive indices as described above, so that the light efficiency of the light emitting element ED, or the light emission efficiency of lights emitted from the light emitting element ED and the viewing angle characteristics may be controlled as desired.

According to the embodiments described with reference to FIG. 8, afterimages may be reduced by effectively improving optical characteristics of green light.

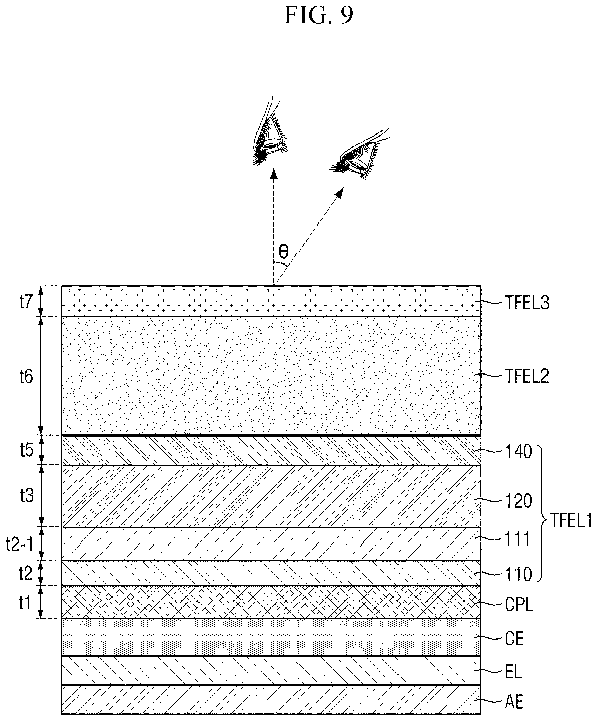

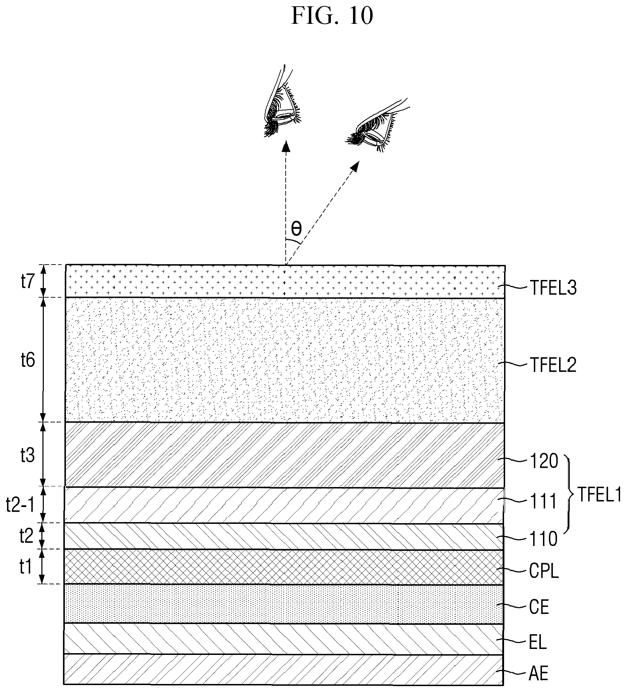

FIG. 9 is a cross-sectional view illustrating in detail a stacked structure of a light emitting element and an encapsulation layer of a display device according to some embodiments. FIG. 10 is a cross-sectional view illustrating in more detail a stacked structure of a light emitting element and an encapsulation layer of a display device according to some embodiments.

Referring to FIG. 9, the display device 10 according to some embodiments may be the same except for a configuration of the first encapsulation layer TFEL1 different from that of the embodiments of FIG. 8. Accordingly, a configuration of the first encapsulation layer TFEL1 different from that of FIG. 8 will be described.

The first encapsulation layer TFEL1 may include multiple layers having different refractive indices. As the capping layer CPL and the multilayer first encapsulation layer TFEL1 have different refractive indices, light may be reflected at an interface between them. The display device 10 may control the light efficiency (or, luminous efficiency) and viewing angle characteristics of the light emitting element ED as desired by arranging optical layers capable of reflecting the light on the light emitting element ED using layers having different refractive indices.

According to some embodiments, the first encapsulation layer TFEL1 in the display device 10 may include a plurality of inorganic insulating layers 110, 111, 120, and 140. The plurality of inorganic insulating layers 110, 111, 120, and 140 include a first optical layer 110, a second optical layer 111, a moisture barrier layer 120, and an upper layer 140 arranged sequentially on the capping layer CPL. Layers sequentially arranged from the capping layer CPL to the upper layer 140 may include different materials and may have different refractive indices and thicknesses.

In addition to the capping layer CPL, the first optical layer 110 and the second optical layer 111 may act as optical layers by allowing reflection of light at the interface between them.

The first optical layer 110 may include at least one of silicon oxide (SiOx), silicon nitride (SiNx), or silicon oxynitride (SiOxNy). The optical layer 110 may be located on the capping layer CPL and may have the lower refractive index than the capping layer CPL. For example, the optical layer 110 may have a refractive index n2 of 1.20 to 1.62 and a thickness t2 of 40 nm (400 Å) to 200 nm (2000 Å). According to some embodiments, the optical layer 110 may include silicon oxynitride (SiOxNy), have a refractive index n2 of 1.57, and have a thickness t2 of 85 nm (850 Å).

The second optical layer 111 may include at least one of silicon oxide (SiOx), silicon nitride (SiNx), or silicon oxynitride (SiOxNy). The second optical layer 111 may be located on the first optical layer 110 and have a higher refractive index than the first optical layer 110. For example, the second optical layer 111 may have a refractive index n2-1 of 1.48 to 1.89 and a thickness t2-1 of 40 nm (400 Å) to 200 nm (2000 Å). According to some embodiments, the moisture barrier layer 120 may include silicon nitride (SiNx), have a refractive index n3 of 1.89, and have a thickness t3 of 125 nm (1250 Å).

The capping layer CPL, the first optical layer 110 and the second optical layer 111 described above may be layers that have a major effect on the optical characteristics of the display device 10. The thickness and refractive index of the layers may need to be precisely controlled to achieve resonance characteristics for each target wavelength. Ranges of thicknesses and refractive indices of each layer may be ranges designed to have optical characteristics targeted by the display device 10.

The moisture barrier layer 120 may include at least one of silicon oxide (SiOx), silicon nitride (SiNx), or silicon oxynitride (SiOxNy). The moisture barrier layer 120 may be located on the optical layer 110 and have a higher refractive index than the optical layer 110. For example, the moisture barrier layer 120 may have a refractive index n3 of 1.50 to 1.70 and a thickness t3 of 400 nm (4000 Å) to 900 nm (9000 Å). According to some embodiments, the moisture barrier layer 120 may include silicon nitride (SiNx), have a refractive index n3 of 1.62, and have a thickness t3 of 800 nm (8000 Å).

The moisture barrier layer 120 may be a layer that has relatively little effect on optical characteristics in the first encapsulation layer TFEL1 and may be a layer for securing reliability such as moisture vapor transmission and oxidation prevention or reduction. Accordingly, the moisture barrier layer 120 may have a relatively large thickness (t3, 400 nm (4000 Å) or more).

The upper layer 140 may include at least one of O-rich silicon oxide (SiOx), silicon nitride (SiNx), or silicon oxynitride (SiOxNy). According to some embodiments, the upper layer 140 may include O-rich SiOxNy. The upper layer 140 may have a refractive index n5 of 1.50 and a thickness t5 of 80 nm (800 Å).

As shown in FIG. 10, the upper layer 140 may be omitted from the configuration of the first encapsulation layer TFEL1 of FIG. 9. According to some embodiments, because the refractive index of the moisture barrier layer 120 is 1.62 and the refractive index of the second encapsulation layer TFEL2 is 1.5, the difference in refractive index between the moisture barrier layer 120 and the second encapsulation layer TFEL2 is relatively insignificant. Therefore, the upper layer 140 may be omitted.

According to the embodiments of FIGS. 9 and 10, power consumption of the display substrate may be relatively reduced by effectively improving optical characteristics of green light.

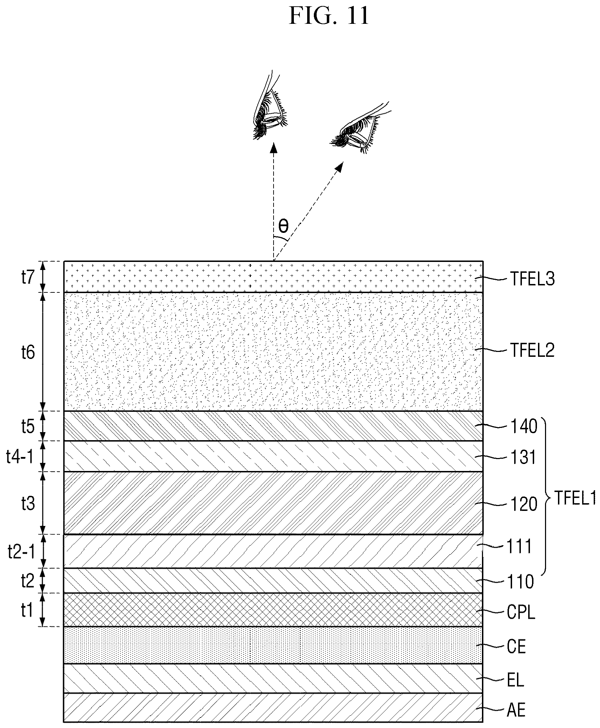

FIG. 11 is a cross-sectional view illustrating in more detail the laminated structure of the light emitting element and the envelope layer of a display device according to some embodiments.

Referring to FIG. 11, the display device 10 according to some embodiments may be the same as the embodimenta of FIG. 9 except that the first encapsulation layer TFEL1 includes a buffer layer. Accordingly, a configuration of the first encapsulation layer TFEL1 different from that of FIG. 9 will be described.

The first encapsulation layer TFEL1 may include multiple layers having different refractive indices. As the capping layer CPL and the multilayer first encapsulation layer TFEL1 have different refractive indices, light may be reflected at an interface between them. The display device 10 arranges optical layers capable of reflecting light on the light emitting element ED using layers having different refractive indices, so that light efficiency (or light emission efficiency) and viewing angle characteristics of the light emitting element ED may be controlled as desired.

According to some embodiments, the first encapsulation layer TFEL1 in the display device 10 may include a plurality of inorganic insulating layers 110, 111, 120, 131, and 140. The plurality of inorganic insulating layers 110, 111, 120, 131, and 140 may include the first optical layer 110, the second optical layer 111, the moisture barrier layer 120, the buffer layer 131, and an upper layer 140 arranged sequentially on the capping layer CPL. The layers sequentially arranged from the capping layer CPL to the upper layer 140 may include different materials and may have different refractive indices and thicknesses.

In addition to the capping layer CPL, the first optical layer 110 and the second optical layer 111 may act as optical layers by allowing reflection of light at the interface between them.

The first optical layer 110 may include at least one of silicon oxide (SiOx), silicon nitride (SiNx), or silicon oxynitride (SiOxNy). The optical layer 110 may be located on the capping layer CPL and may have a lower refractive index than the capping layer CPL. For example, the optical layer 110 may have a refractive index n2 of 1.20 to 1.62 and a thickness t2 of 40 nm (400 Å) to 200 (nm) 2000 Å. According to some embodiments, the optical layer 110 may include silicon oxynitride (SiOxNy), have a refractive index n2 of 1.57, and have a thickness t2 of 85 nm (850 Å).

The second optical layer 111 may include at least one of silicon oxide (SiOx), silicon nitride (SiNx), or silicon oxynitride (SiOxNy). The second optical layer 111 may be located on the first optical layer 110 and have a higher refractive index than the first optical layer 110. For example, the second optical layer 111 may have a refractive index (n2-1) of 1.20 to 1.62 and a thickness (t2-1) of 40 nm (400 Å) to 200 nm (2000 Å). According to some embodiments, the moisture barrier layer 120 may include silicon nitride (SiNx), have a refractive index n3 of 1.89, and have a thickness t3 of 125 nm (1250 Å).

The capping layer CPL, the first optical layer 110, and the second optical layer 111 described above may be layers that have a major effect on the optical characteristics of the display device 10. The thickness and refractive index of the layers may need to be precisely controlled to achieve resonance characteristics for each target wavelength. Ranges of thicknesses and refractive indices of each layer may be ranges designed to have optical characteristics targeted by the display device 10.

The moisture barrier layer 120 may include at least one of silicon oxide (SiOx), silicon nitride (SiNx), or silicon oxynitride (SiOxNy). The moisture barrier layer 120 may be located on the optical layer 110 and have a higher refractive index than the optical layer 110. For example, the moisture barrier layer 120 may have a refractive index n3 of 1.50 to 1.70 and a thickness t3 of 400 nm (4000 Å) to 900 nm (9000 Å). According to some embodiments, the moisture barrier layer 120 may include silicon nitride (SiNx), have a refractive index n3 of 1.62, and have a thickness t3 of 800 nm (8000 Å).

The moisture barrier layer 120 may be a layer that has relatively little effect on optical characteristics in the first encapsulation layer TFEL1 and may be a layer for securing reliability such as moisture vapor transmission and oxidation prevention or reduction. Accordingly, the moisture barrier layer 120 may have a relatively large thickness (t3, 400 nm (4000 Å) or more).

The buffer layer 131 may include at least one of silicon oxide (SiOx), silicon nitride (SiNx), or silicon oxynitride (SiOxNy). The auxiliary layer 130 is located on the moisture barrier layer 120 and may have a smaller refractive index than the moisture barrier layer 120. For example, the auxiliary layer 130 may have a refractive index n4-of 1.48 to 1.89 and a thickness t4-1 of 65 nm (650 Å) or more. According to some embodiments, the buffer layer 131 may include silicon oxynitride (SiOxNy), have a refractive index n4-1 of 1.57, and have a thickness t4-1 of 80 nm (800 Å).

The buffer layer 131 may reduce dispersion on color coordinates.

The upper layer 140 is located on the buffer layer 131. The upper layer 140 may include at least one of O-rich silicon oxide (SiOx), silicon nitride (SiNx), or silicon oxynitride (SiOxNy). According to some embodiments, the upper layer 140 may include O-rich SiOxNy. The upper layer 140 may have a refractive index n5 of 1.50 and a thickness t5 of 80 nm (800 Å).

The display device 10 may greatly reduce the dispersion of movement trajectories in the color temperature direction in the color coordinate system by adjusting the thickness and refractive index of the buffer layer 131 and control it within a desired region.

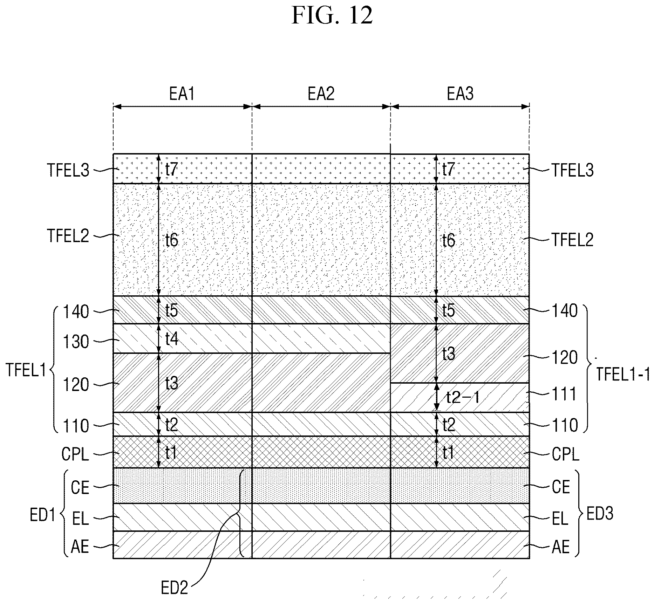

FIGS. 12 to 15 are cross-sectional views illustrating a stacked structure of a light emitting element and an encapsulation layer of a display device according to some embodiments in more detail.

The light emitting regions emitting light of different wavelengths according to the embodiments of FIGS. 12 to 15 include encapsulation layers having different stacked structures.

Referring to FIG. 12, the display device 10 according to some embodiments includes the first light emitting area EA1, the second light emitting area EA2, and the third light emitting area EA3. The third light emitting area EA3 is also termed as a second light emitting area EA3 in the claims and general part of the description and may be termed as an additional light emitting area.

The first light emitting area EA1 includes a first light emitting element ED1 emitting light of a first wavelength. The central wavelength band of the first light emitting element ED1 has a range of 600 nm to 680 nm. The second light emitting area EA2 includes a second light emitting element ED2 emitting light of a second wavelength. The central wavelength band of the second light emitting element ED2 has a range of 500 nm to 580 nm. The third light emitting area EA3 includes a third light emitting element ED2 emitting light of a third wavelength. A central wavelength band of the third light emitting element ED3 has a range of 420 nm to 480 nm. Also, the third light emitting element ED3 is termed as a second light emitting element ED3 in the claims and general part of the description and may be termed as an additional light emitting element.

The light emitting areas EA1, EA2, and EA3 emitting light of different wavelengths may include first encapsulation layers TFEL1 having different stacked structures.

For example, the stack structure of a first encapsulation layer TFEL1 (which may be termed as a first light emitting area encapsulation layer) of the first light emitting area EA1 and the second light emitting area EA2 is the same as each other and is different from the stacking structure of the first encapsulation layer TFEL1-1 (which may be termed as a second light emitting area encapsulation layer) of the third light emitting area EA3. The first light emitting area EA1 may include the capping layer CPL, the first encapsulation layer TFEL1, the second encapsulation layer TFEL2, and a third encapsulation layer TFEL3 sequentially arranged on the first light emitting element ED1. The first encapsulation layer TFEL1 may include the optical layer 110, the moisture barrier layer 120 (also termed as a first moisture barrier layer 120 in the claims and general part of the description), the auxiliary layer 130, and the upper layer 140 sequentially arranged on the capping layer CPL. The refractive indices and thicknesses of the optical layer 110, the moisture barrier layer 120, the auxiliary layer 130, and the upper layer 140 are referred to in FIG. 8. The second light emitting area EA2 may include the capping layer CPL, the first encapsulation layer TFEL1, the second encapsulation layer TFEL2, and the third encapsulation layer TFEL3 sequentially arranged on the second light emitting element ED2. The first encapsulation layer TFEL1 of the second light emitting area EA2 has the same stacked structure as the first encapsulation layer TFEL1 of the first light emitting area EA1. The third light emitting area EA3 may include the capping layer CPL, the first encapsulation layer TFEL1-1, the second encapsulation layer TFEL2, and the third encapsulation layer TFEL3 arranged sequentially on the third light emitting element ED3. The first encapsulation layer TFEL1-1 of the third light emitting element ED3 may include the first optical layer 110, the second optical layer 111, the moisture barrier layer 120 (also termed as a second moisture barrier layer 120 in the claims and general part of the description), the upper layer 140 arranged sequentially on the capping layer CPL. The refractive indices and thicknesses of the first optical layer 110, the second optical layer 111, the moisture barrier layer 120, and the upper layer 140 are referred to in FIG 9.

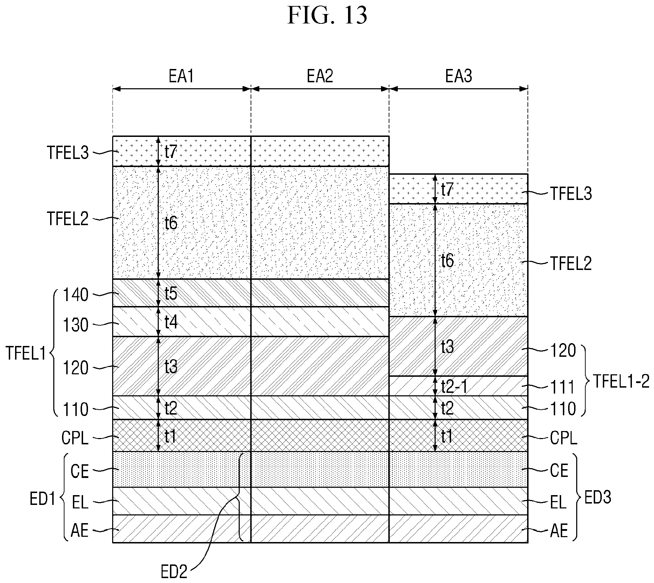

Referring to FIG. 13, the display device 10 according to some embodiments includes the first light emitting area EA1, the second light emitting area EA2, and the third light emitting area EA3. The third light emitting area EA3 is also termed as a second light emitting area EA3 in the claims and general part of the description and may be termed as an additional light emitting area.

The first light emitting area EA1 includes a first light emitting element ED1 emitting light of a first wavelength. The central wavelength band of the first light emitting element ED1 has a range of 420 nm to 480 nm. The second light emitting area EA2 includes a second light emitting element ED2 emitting light of a second wavelength. The central wavelength band of the second light emitting element ED2 has a range of 500 nm to 580 nm. The third light emitting area EA3 includes a third light emitting element ED2 emitting light of a third wavelength. The central wavelength band of the third light emitting element ED3 has a range of 600 nm to 680 nm. Also, the third light emitting element ED3 is termed as a second light emitting element ED3 in the claims and general part of the description and may be termed as an additional light emitting element.

The light emitting areas EA1, EA2, and EA3 emitting light of different wavelengths may include first encapsulation layers TFEL1 having different stacked structures.

For example, the stack structure of the first encapsulation layer TFEL1 of the first light emitting area EA1 and the second light emitting area EA2 is the same as each other and is different from the stacked structure of the first encapsulation layer TFEL1-2 of the third light emitting area EA3. The first light emitting area EA1 may include the capping layer CPL, the first encapsulation layer TFEL1, the second encapsulation layer TFEL2, and the third encapsulation layer TFEL3 arranged sequentially on the first light emitting element ED1. The first encapsulation layer TFEL1 may include the optical layer 110, the moisture barrier layer 120 (also termed as a first moisture barrier layer 120 in the claims and general part of the description), the auxiliary layer 130, and the upper layer 140 sequentially arranged on the capping layer CPL. The refractive indices and thicknesses of the optical layer 110, the moisture barrier layer 120, the auxiliary layer 130, and the upper layer 140 are referred to in FIG 8. The second light emitting area EA2 may include the capping layer CPL, the first encapsulation layer TFEL1, the second encapsulation layer TFEL2, and the third encapsulation layer TFEL3 sequentially arranged on the second light emitting element ED2. The first encapsulation layer TFEL1 of the second light emitting area EA2 has the same stacked structure as the first encapsulation layer TFEL1 of the first light emitting area EA1. The third light emitting area EA3 may include the capping layer CPL, the first encapsulation layer TFEL1-2, the second encapsulation layer TFEL2, and the third encapsulation layer TFEL3 arranged sequentially on the third light emitting element ED3. The first encapsulation layers TFEL1-2 of the third light emitting area EA3 may include the first optical layer 110, the second optical layer 111, and the moisture barrier layer 120 (also termed as a second moisture barrier layer 120 in the claims and general part of the description) sequentially arranged on the capping layer CPL. The refractive indices and thicknesses of the first optical layer 110, the second optical layer 111, and the moisture barrier layer 120 are shown in FIG. 10.

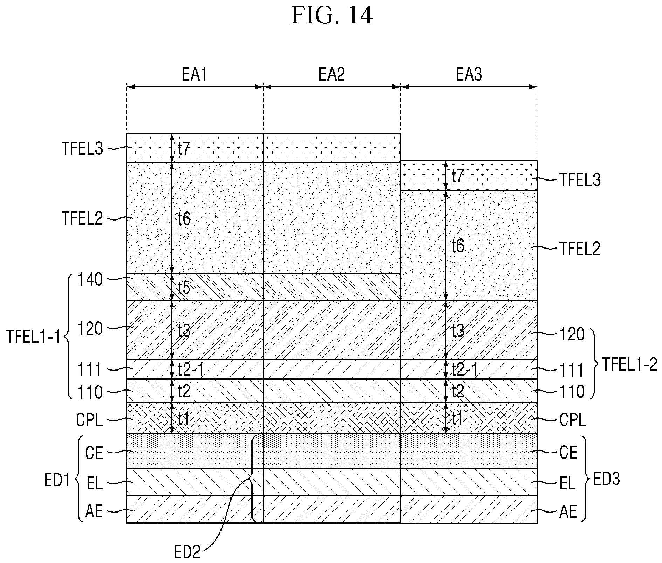

Referring to FIG. 14, the display device 10 according to some embodiments includes the first light emitting area EA1, the second light emitting area EA2, and the third light emitting area EA3. The third light emitting area EA3 is also termed as a second light emitting area EA3 in the claims and general part of the description and may be termed as an additional light emitting area.

The first light emitting area EA1 includes a first light emitting element ED1 emitting light of a first wavelength. The central wavelength band of the first light emitting element ED1 has a range of 420 nm to 480 nm. The second light emitting area EA2 includes a second light emitting element ED2 emitting light of a second wavelength. The central wavelength band of the second light emitting element ED2 has a range of 500 nm to 580 nm. The third light emitting area EA3 includes a third light emitting element ED2 emitting light of a third wavelength. The central wavelength band of the third light emitting element ED3 has a range of 600 nm to 680 nm. Also, the third light emitting element ED3 is termed as a second light emitting element ED3 in the claims and general part of the description and may be termed as an additional light emitting element.

The light emitting areas EA1, EA2, and EA3 emitting light of different wavelengths may include first encapsulation layers TFEL1 having different stacked structures.

For example, the stack structure of the first encapsulation layer TFEL1-1 of the first light emitting area EA1 and the second light emitting area EA2 is the same as each other and is different from the stacked structure of the first encapsulation layer TFEL1-2 of the third light emitting area EA3. The first light emitting area EA1 may include the capping layer CPL, the first encapsulation layer TFEL1-1, the second encapsulation layer TFEL2, and the third encapsulation layer TFEL3 arranged sequentially on the first light emitting element ED1. The first encapsulation layer TFEL1-1 may include the first optical layer 110, the second optical layer 111, the moisture barrier layer 120, and the upper layer 140 arranged sequentially on the capping layer CPL. The refractive indices and thicknesses of the first optical layer 110, the second optical layer 111, the moisture barrier layer 120, and the upper layer 140 are referred to in FIG 9.

The second light emitting area EA2 may include the capping layer CPL, the first encapsulation layer TFEL1-1, the second encapsulation layer TFEL2, and the third encapsulation layer TFEL3 arranged sequentially on the second light emitting element ED2. The first encapsulation layer TFEL1-1 of the second light emitting area EA2 has the same stacked structure as the first encapsulation layer TFEL1-1 of the first light emitting area EA1. The third light emitting area EA3 may include the capping layer CPL, the first encapsulation layer TFEL1-2, the second encapsulation layer TFEL2, and the third encapsulation layer TFEL3 arranged sequentially on the third light emitting element ED3. The first encapsulation layers TFEL1-2 of the third light emitting area EA3 may include the first optical layer 110, the second optical layer 111, and the moisture barrier layer 120 arranged sequentially on the capping layer CPL. The refractive indices and thicknesses of the first optical layer 110, the second optical layer 111, and the moisture barrier layer 120 are shown in FIG. 10.

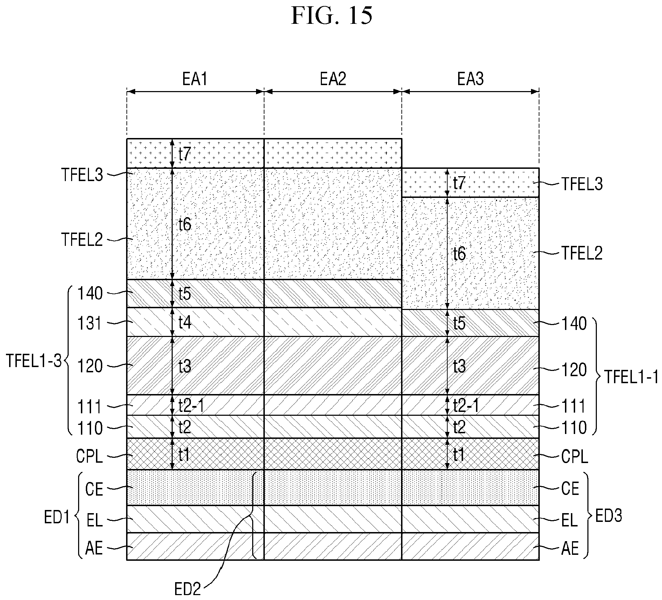

Referring to FIG. 15, the display device 10 according to some embodiments includes the first light emitting area EA1, the second light emitting area EA2, and the third light emitting area EA3. The third light emitting area EA3 is also termed as a second light emitting area EA3 in the claims and general part of the description and may be termed as an additional light emitting area.

The first light emitting area EA1 includes the first light emitting element ED1 emitting light of a first wavelength. The central wavelength band of the first light emitting element ED1 has a range of 420 nm to 480 nm. The second light emitting area EA2 includes a second light emitting element ED2 emitting light of a second wavelength. The central wavelength band of the second light emitting element ED2 has a range of 500 nm to 580 nm. The third light emitting area EA3 includes a third light emitting element ED2 emitting light of a third wavelength. The central wavelength band of the third light emitting element ED3 has a range of 600 nm to 680 nm. Also, the third light emitting element ED3 is termed as a second light emitting element ED3 in the claims and general part of the description and may be termed as an additional light emitting element.

The light emitting areas EA1, EA2, and EA3 emitting light of different wavelengths may include first encapsulation layers TFEL1 having different stacked structures.

For example, the stack structure of the first encapsulation layer TFEL1-3 of the first light emitting area EA1 and the second light emitting area EA2 is identical to each other and is different from the stacked structure of the first encapsulation layer TFEL1-1 of the third light emitting area EA3. The first light emitting area EA1 may include the capping layer CPL, the first encapsulation layer TFEL1-3, the second encapsulation layer TFEL2, and the third encapsulation layer TFEL3) arranged sequentially on the first light emitting element ED1. The first encapsulation layer TFEL1-3 may include the first optical layer 110, the second optical layer 111, the moisture barrier layer 120, the auxiliary layer 130, the buffer layer 131, and the upper layer 140 arranged sequentially on the capping layer CPL. The refractive indices and thicknesses of the first optical layer 110, the second optical layer 111, the moisture barrier layer 120, the auxiliary layer 130, the buffer layer 131, and the upper layer 140 are referred to in FIG 11. The second light emitting area EA2 includes the capping layer CPL, the first encapsulation layer TFEL1-3, the second encapsulation layer TFEL2, and the third encapsulation layer TFEL3 sequentially arranged on the second light emitting element ED2. The first encapsulation layer TFEL1-3 of the second light emitting area EA2 has the same stacked structure as the first encapsulation layer TFEL1-3 of the first light emitting area EA1. The third light emitting area EA3 may include the capping layer CPL, the first encapsulation layer TFEL1-1, the second encapsulation layer TFEL2, and the third encapsulation layer TFEL3 arranged sequentially on the third light emitting element ED3. The first encapsulation layer TFEL1-1 of the third light emitting element ED3 may include the first optical layer 110, the second optical layer 111, the moisture barrier layer 120, and the upper layer 140 arrranged sequentially on the capping layer CPL. The refractive indices and thicknesses of the first optical layer 110, the second optical layer 111, the moisture barrier layer 120, and the upper layer 140 are referred to in FIG 9.

As described above, touch sensitivity may be improved by reducing the dielectric constant and thickness of the second encapsulation layer TFEL2.

In addition, the light efficiency of each light emitting area, the light output efficiency of each light emitting area, and viewing angle characteristics may be controlled as desired by differentiating the stacking structure of the encapsulation layer between the light emitting areas emitting light of different wavelengths.

However, the aspects of embodiments according to the present invention are not restricted to the one set forth herein. The above and other aspects of embodiments according to the present invention will become more apparent to one of daily skill in the art to which the invention pertains by referencing the claims.

## Claims

1. A display device (10) comprising:
a first light emitting element (ED1) in a first light emitting area (EA1) and configured to emit light of a first wavelength;
a second light emitting element (ED3) in a second light emitting area (EA3) and configured to emit light of a second wavelength;
a capping layer (CPL) on the first light emitting element (ED1) and the second light emitting element (ED3);
a first light emitting area encapsulation layer (TFEL1 , TFEL1-1, TFEL1-3) on the capping layer (CPL) at the first light emitting area (EA1) and including a plurality of inorganic insulating layers (110, 111, 120, 130, 131, 140);
a second light emitting area encapsulation layer (TFEL1-1, TFEL1-2) on the capping layer (CPL) at the second light emitting area (EA3) and including a plurality of inorganic insulating layers (110, 111, 120, 130, 131, 140); and
a second encapsulation layer (TFEL2) and a third encapsulation layer (TFEL3) sequentially on the first light emitting area encapsulation layer (TFEL1, TFEL1-1, TFEL1-3) and the second light emitting area encapsulation layer (TFEL1-1, TFEL1-2),
wherein a thickness and a refractive index of a plurality of inorganic insulating layers (110, 111, 120, 130, 131, 140) of the second light emitting area encapsulation layer (TFEL1-1, TFEL1-2) are different from a thickness and a refractive index of a plurality of inorganic insulating layers (110, 111, 120, 130, 131, 140) of the first light emitting area encapsulation layer (TFEL1, TFEL1-1, TFEL1-3).

2. The display device (10) of claim 1, wherein a dielectric constant of the second encapsulation layer (TFEL2) is in a range of 3.0 or less.

3. The display device (10) of claim 1 or 2, wherein the second encapsulation layer (TFEL2) has a thickness in a range of 8 µm to 9 µm or 10 µm to 11 µm.

4. The display device (10) of at least one of claims 1 to 3, wherein the first light emitting area encapsulation layer (TFEL1, TFEL1-1, TFEL1-3) sequentially includes an optical layer (110), a first moisture barrier layer (120), an auxiliary layer (130), and an upper layer (140),
wherein the second light emitting area encapsulation layer (TFEL1-1, TFEL1-2) sequentially includes a first optical layer (110), a second optical layer (111), a second moisture barrier layer (120), and an upper layer (140).

5. The display device (10) of at least one of claims 1 to 3, wherein the first light emitting area encapsulation layer (TFEL1, TFEL1-1, TFEL1-3) sequentially includes an optical layer (110), a first moisture barrier layer (120), an auxiliary layer (130), and an upper layer (140),
wherein the second light emitting area encapsulation layer (TFEL1-1, TFEL1-2) sequentially includes a first optical layer (110), a second optical layer (111), and a second moisture barrier layer (120).

6. The display device (10) of claim 4 or 5, wherein the optical layer (110) and the first optical layer (110) include silicon oxynitride,
wherein the first moisture barrier layer (120) and the second optical layer (111) include silicon nitride,
wherein the auxiliary layer (130) and the second moisture barrier layer (120) include silicon oxynitride,
wherein the upper layer (140) includes silicon oxynitride havinga higher oxygen content than at least one of the optical layer (110), the first optical layer (110), the auxiliary layer (130) and the second moisture barrier layer (120).

7. The display device (10) of at least one of claims 4 to 6, wherein the optical layer (110) and the first optical layer (110) have a refractive index in the range of 1.20 to 1.62,
wherein the first moisture barrier layer (120) and the second optical layer (111) have a refractive index in a range of 1.70 to 1.90,
wherein the auxiliary layer (130) and the second moisture barrier layer (120) have a refractive index in a range of 1.50 to 1.62, and the refractive index of the auxiliary layer (130) and/or the second moisture barrier layer (120) is greater than the optical layer (110) and the first optical layer (110),
wherein the upper layer (140) has a refractive index in a range of 1.50 to 1.80, and the refractive index of the upper layer (140) is smaller than that of the auxiliary layer (130) and/or the second moisture barrier layer (120).

8. The display device (10) of at least one of claims 4 to 7, wherein the optical layer (110), the first optical layer (110), and the second optical layer (111) have a thickness in a range of 40 nm to 200 nm, the second optical layer (111) especially is thicker than the thickness of the first optical layer (110),
wherein the first moisture barrier layer (120) and the second moisture barrier layer (120) have a thickness in a range of 400 nm to 900 nm,
wherein the auxiliary layer (130) and the upper layer (140) have a thickness in a range of 60 nm to 140 nm, and the upper layer (140) is thicker than the auxiliary layer (130).

9. The display device (10) of claim 8, wherein the optical layer (110) has a thickness of 100 nm, the first moisture barrier layer (120) has a thickness of 900 nm, the auxiliary layer (130) has a thickness of 65 nm, and the upper layer (140) has a thickness of 80 nm,
wherein the first optical layer (110) has a thickness of 85 nm, the second optical layer (111) has a thickness of 125 nm, and the second moisture barrier layer (120) has a thickness of 800 nm.

10. The display device (10) of at least one of claims 1 to 3, wherein the first light emitting area encapsulation layer (TFEL1, TFEL1-1, TFEL1-3) sequentially includes a first optical layer (110), a second optical layer (111), a moisture barrier layer (120), and an upper layer (140),
wherein the second light emitting area encapsulation layer (TFEL1-1, TFEL1-2) sequentially includes a first optical layer (110), a second optical layer (111), and a moisture barrier layer (120),
wherein the second encapsulation layer (TFEL2) is directly on the moisture barrier layer (120).

11. The display device (10) of claim 10, wherein the first optical layer (110) includes silicon oxynitride,
wherein the second optical layer (111) includes silicon nitride,
wherein the moisture barrier layer (120) includes silicon oxynitride,
wherein the upper layer (140) includes silicon oxynitride having a higher oxygen content than the moisture barrier layer (120).

12. The display device (10) of claim 10 or 11, wherein the first optical layer (110) has a refractive index in a range of 1.20 to 1.62,
wherein the second optical layer (111) has a refractive index in a range of 1.70 to 1.90,
wherein the moisture barrier layer (120) has a refractive index in a range of 1.50 to 1.62, and the refractive index of the moisture barrier layer (120) is greater than the first optical layer (110),
wherein the upper layer (140) has a refractive index in a range of 1.50 to 1.80, and the refractive index of the upper layer (140) is smaller than that of the moisture barrier layer (120).

13. The display device (10) of at least one of claims 10 to 12, wherein the first optical layer (110) and the second optical layer (111) have thicknesses in the range of 40 nm to 200 nm, the second optical layer (111) is thicker than the first optical layer (110),
wherein the moisture barrier layer (120) has a thickness in a range of 400 nm to 900 nm,
wherein the upper layer (140) has a thickness in a range 60 nm Å to 140 nm.

14. The display device (10) of claim 13, wherein the first optical layer (110) has a thickness of 85 nm, the second optical layer (111) has a thickness of 125 nm, the moisture barrier layer (120) has a thickness of 800 nm, and the upper layer (140) has a thickness of 80 nm.

15. The display device (10) of at least one of claims 1 to 3, wherein the first light emitting area encapsulation layer (TFEL1, TFEL1-1, TFEL1-3) sequentially includes a first optical layer (110), a second optical layer (111), a moisture barrier layer (120), a buffer layer (131), and an upper layer (140),
wherein the second light emitting area encapsulation layer (TFEL1-1, TFEL1-2) sequentially includes a first optical layer (110), a second optical layer (111), a moisture barrier layer (120), and an upper layer (140).

16. The display device (10) of claim 15, wherein the first optical layer (110) includes silicon oxynitride,
wherein the second optical layer (111) includes silicon nitride,
wherein the moisture barrier layer (120) and the buffer layer (131) include silicon oxynitride,
wherein the upper layer (140) includes silicon oxynitride having a higher oxygen content than the moisture barrier layer (120) and the buffer layer (131).

17. The display device (10) of claim 15 or 16, wherein the first optical layer (110) has a refractive index in a range of 1.20 to 1.62,
wherein the second optical layer (111) has a refractive index in a range of 1.70 to 1.90,
wherein the moisture barrier layer (120) has a refractive index in a range of 1.50 to 1.62, and the refractive index of the moisture barrier layer (120) is greater than the first optical layer (110),
wherein the upper layer (140) has a refractive index in a range of 1.50 to 1.80,
wherein the buffer layer (131) has a refractive index smaller than that of the moisture barrier layer (120) and greater than that of the upper layer (140).

18. The display device (10) of at least one of claims 15 to 17, wherein the first optical layer (110) and the second optical layer (111) have a thickness in a range of 40 nm to 200 nm, the second optical layer (111) is thicker than the first optical layer (110),
wherein the moisture barrier layer (120) has a thickness in a range of 400 nm to 900 nm,
wherein the buffer layer (131) and the upper layer (140) have a thickness in a range of 60 nm to 140 nm.

19. The display device (10) of claim 18, wherein the first optical layer (110) has a thickness of 85 nm, the second optical layer (111) has a thickness of 125 nm, the moisture barrier layer (120) has a thickness of 800 nm, the buffer layer (131) has a thickness of 80 nm, and the upper layer (140) has a thickness of 80 nm.

20. The display device (10) of at least one of claims 4 to 19, wherein the capping layer (CPL) has a refractive index greater than that of the first optical layer (110).

21. The display device (10) of at least one of claims 1 to 20, comprising a light conversion layer (OCL) on the third encapsulation layer (TFEL3),
wherein the light conversion layer (OCL) is one of a color filter or a polarizing plate.

22. The display device (10) of at least one of claims 1 to 21, wherein the display device (10) comprises
a display layer (DU) including a display area (DA) and a non-display area (NDA) surrounding the display area (DA),
a touch sensor layer (TSU) overlapping a portion of the display area (DA) of the display device (10),
and a light conversion layer (OCL) on the touch sensor layer (TSU) and overlapping a portion of the display area (DA).
